(19)

Europäisches Patentamt

European Patent Office

Office européen des brevets

(11)  **EP 4 682 220 A1**

(12)  **EUROPEAN PATENT APPLICATION**

published in accordance with Art. 153(4) EPC

(43) Date of publication:
**21.01.2026 Bulletin 2026/04**

(21) Application number: **24770729.2**

(22) Date of filing: **07.03.2024**

(51) International Patent Classification (IPC):
**C09K 5/14** (2006.01)   **F25B 9/00** (2006.01)
**F25B 9/12** (2006.01)

(52) Cooperative Patent Classification (CPC):
**C09K 5/14; F25B 9/00; F25B 9/12**

(86) International application number:
**PCT/JP2024/008875**

(87) International publication number:
**WO 2024/190623 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.03.2023   JP 2023039304**

(71) Applicant: **Niterra Materials Co., Ltd.
Yokohama-shi, Kanagawa 235-0032 (JP)**

(72) Inventors:
• **TAGUCHI, Seina**
**Yokohama-shi**
**Kanagawa 235-0032 (JP)**
• **KONDO, Hiroyasu**
**Yokohama-shi**
**Kanagawa 235-0032 (JP)**
• **USUI, Daichi**
**Yokohama-shi**
**Kanagawa 235-0032 (JP)**

(74) Representative: **Henkel & Partner mbB
Patentanwaltskanzlei, Rechtsanwaltskanzlei
Maximiliansplatz 21
80333 München (DE)**

(54)  **GRANULATED PARTICLES FOR COLD STORAGE MATERIAL PARTICLES, GRANULATED PARTICLE GROUP FOR COLD STORAGE MATERIAL PARTICLES, COLD STORAGE MATERIAL PARTICLES, COLD STORAGE MATERIAL PARTICLE GROUP, COLD STORAGE DEVICE, REFRIGERATOR, CRYOPUMP, SUPERCONDUCTING MAGNET, NUCLEAR MAGNETIC RESONANCE IMAGING APPARATUS, NUCLEAR MAGNETIC RESONANCE APPARATUS, MAGNETIC FIELD APPLICATION-TYPE SINGLE CRYSTAL PULLING APPARATUS, HELIUM RECONDENSATION APPARATUS, AND DILUTION REFRIGERATOR**

(57)   Granulated particles for cold storage material particles according to one embodiment contain a rare earth oxysulfide that contains at least one rare earth element selected from the group consisting of Y, La, Ce, Pr, Nd, Sm, Eu, Gd, Tb, Dy, Ho, Er, Tm, Yb and Lu, or a rare earth oxide that contains at least one rare earth element, and the granulated particles each have a plurality of recessed parts in the surface, the outer edge of each recessed part being a closed curve.

【Fig.1】

EP 4 682 220 A1

**Description**

TECHNICAL FIELD

Embodiments described herein relate generally to a granulated particle for cold storage material particle, a granulated particle group for cold storage material particles, a cold storage material particle, a cold storage material particle group, a cold storage device, a refrigerator, a cryopump, a superconducting magnet, a nuclear magnetic resonance imaging apparatus, a nuclear magnetic resonance apparatus, a magnetic field application type single crystal pulling apparatus, a helium re-condensing device, and a dilution refrigerator.

BACKGROUND ART

In recent years, superconducting technologies have been remarkably developed, and it is necessary to develop compact and high-performance cryogenic refrigerators as the fields to which the superconducting technologies are applied have expanded. The cryogenic refrigerators are required to be lightweight, compact, and highly thermally efficient. The cryogenic refrigerators have been put into practical use in various application fields.

A cryogenic refrigerator includes a cold storage device filled with a plurality of cold storage materials. For example, cold is generated by heat exchange between the cold storage material and helium gas passing through the cold storage device. For example, in a cryopump or the like used in a superconducting MRI apparatus, a semiconductor manufacturing device, or the like, a refrigerator using a refrigeration cycle of a Gifford-McMahon (GM) type, a Stirling type, or a pulse tube type is used.

In addition, a high-performance refrigerator is also required for a magnetically levitated train in order to generate a magnetic force using a superconducting magnet. Furthermore, in recent years, a high-performance refrigerator has also been used in a superconducting magnetic energy storage (SMES), a magnetic field application type single crystal pulling apparatus for producing high-quality silicon wafers, or the like. In addition, pulse tube refrigerators, which are expected to have high reliability, are also being actively developed and put into practical use.

Liquid helium used in the superconducting magnet, the MRI apparatus, or the like as described above evaporates, causing a liquid helium supplying issue. In recent years, the helium depletion problem has become serious, and it is difficult to obtain helium, affecting the industry.

In order to reduce the consumption of liquid helium and reduce the burden of maintenance such as replenishment, helium re-condensing devices for re-condensing evaporated helium have been put into practical use, and the demand for the helium re-condensing devices has increased. The helium re-condensing device also uses a GM refrigerator or a pulse tube refrigerator that cools helium to a 4K-level temperature to liquefy the helium.

In a refrigerator, a working medium such as compressed helium (He) gas flows in one direction in a cold storage device filled with a cold storage material, and thermal energy thereof is supplied to the cold storage material. Then, the expanded working medium receives thermal energy from the cold storage material while flowing in the cold storage device in the opposite direction. As the recuperation effect is improved through such a process, thermal efficiency in the working medium cycle is improved, thereby achieving a lower temperature. In order to smoothly exchange thermal energy between the He gas and the cold storage material, the cold storage material desirably has a high thermal conductivity.

Here, as the specific heat per unit volume of the cold storage material filled in the cold storage device is higher, the thermal energy that can be stored in the cold storage material increases, thereby improving the refrigeration capacity of the refrigerator. Therefore, it is desirable to fill a cold storage material having a high volumetric specific heat at a low temperature on the low-temperature side of the cold storage device and fill a cold storage material having a high volumetric specific heat at a high temperature on the high-temperature side of the cold storage device.

A magnetic cold storage material has a high volumetric specific heat in a specific temperature range depending on its composition. Therefore, by combining magnetic cold storage materials having different compositions exhibiting different volumetric specific heats, the cold storage capacity is enhanced, and the refrigeration capacity of the refrigerator is improved.

In addition, as the thermal conductivity and the heat transfer coefficient of the cold storage material filled in the cold storage device are higher, the thermal energy transfer efficiency is improved, and the efficiency of the refrigerator is improved.

In a conventional refrigerator, 4 K refrigeration has been achieved by filling metal cold storage material particles such as lead (Pb), bismuth (Bi), or tin (Sn) on a high-temperature side of a cold storage device, and filling metal-based magnetic cold storage material particles such as $Er_3Ni$, ErNi, or $HoCu_2$, on a low-temperature side of 20 K or less of the cold storage device.

In recent years, it has been attempted to improve the refrigeration capacity of the refrigerator by substituting some of the metal-based magnetic cold storage material particles with ceramic magnetic cold storage material particles having a high specific heat in a temperature range of 2 K to 10 K, such as $Gd_2O_2S$, $Tb_2O_2S$, $Dy_2O_2S$, $Ho_2O_2S$, and $GdAlO_3$.

The refrigeration performance of the refrigerator is determined by how much He gas can be brought into contact with the surfaces of the cold storage material particles. As conventional cold storage material particles, round particles are used in order to realize high-density filling, and it is difficult to fill the particles at a higher density. If too many small cold storage material particles are filled in gaps between the cold storage material particles, the permeability of the He gas, which is a refrigerant, decreases. In addition, it may be considered to fill particles while applying a strong pressure, but if the particles are filled while applying an excessively strong pressure, the cold storage material is pulverized, which causes clogging. For this reason, a cold storage material capable of maintaining high-density filling and improving a contact area with He gas is desired.

CITATION LIST

PATENT LITERATURE

Patent Literature 1: JP 2003-73661 A
Patent Literature 2: JP 2003-213252 A
Patent Literature 3: WO 2018/025581 A1
Patent Literature 4: JP 5656842 B2

SUMMARY OF THE INVENTION

PROBLEM TO BE SOLVED BY THE INVENTION

An object of the present invention is to provide a granulated particle for cold storage material particle for producing a cold storage material particle having an increased specific surface area to improve the refrigeration performance of a refrigerator.

Solution to Problem

MEANS FOR SOLVING PROBLEM

A granulated particle for cold storage material particle according to an embodiment includes a rare earth oxysulfide or a rare earth oxide containing at least one rare earth element selected from the group consisting of Y, La, Ce, Pr, Nd, Sm, Eu, Gd, Tb, Dy, Ho, Er, Tm, Yb, and Lu, in which the granulated particle has a plurality of recesses each having a closed curve at an outer edge on a surface thereof.

BRIEF DESCRIPTION OF THE DRAWINGS

FIG. 1 is a schematic view of a granulated particle for cold storage material particle according to a first embodiment.
FIG. 2 is a schematic view of a cold storage material particle according to a third embodiment.
FIG. 3 is a schematic cross-sectional view illustrating a configuration of a main part of a refrigerator according to a fifth embodiment.
FIG. 4 is a cross-sectional view illustrating a schematic configuration of a cryopump according to a sixth embodiment.
FIG. 5 is a perspective view illustrating a schematic configuration of a superconducting magnet according to a seventh embodiment.
FIG. 6 is a cross-sectional view illustrating a schematic configuration of a nuclear magnetic resonance imaging apparatus according to an eighth embodiment.
FIG. 7 is a cross-sectional view illustrating a schematic configuration of a nuclear magnetic resonance apparatus according to a ninth embodiment.
FIG. 8 is a perspective view illustrating a schematic configuration of a magnetic field application type single crystal pulling apparatus according to a tenth embodiment.
FIG. 9 is a schematic diagram illustrating a schematic configuration of a helium re-condensing device according to an eleventh embodiment.
FIG. 10 is a schematic diagram illustrating a schematic configuration of a dilution refrigerator according to a twelfth embodiment.

EMDODIMENT(S) FOR CARRYING OUT THE INVENTION

Hereinafter, embodiments of the present invention will be described with reference to the drawings. In the following description, the same or similar members and the like will be denoted by the same reference signs, and the description of the members and the like once described may be appropriately omitted.

In the present specification, a cryogenic temperature means, for example, a temperature range in which a superconducting phenomenon can be industrially useful. The cryogenic temperature is, for example, in a temperature range of 20 K or less.

Note that a recess of a granulated particle for cold storage material particle or a recess of a cold storage material particle in this specification is different from a crack. The recess and the crack can be distinguished by, for example, the following procedure. A scanning electron microscope (SEM) image of a particle is imaged, and portions having differences in brightness in the particle is specified. The recess and the crack are distinguished based on a change in difference in brightness when the contrast is increased among the portions having differences in brightness. Among portions that look less bright than the other portions when the SEM image of the particle is captured, a portion having a small difference in brightness from the other portions when the contrast of the SEM image is maximized is a recess. On the other hand, among portions that look less bright than the other portions when the SEM image of the particle is captured, a portion having almost no change in difference in brightness from the other portions when the contrast of the SEM image is maximized or a portion having a large difference in brightness from the other portions when the contrast of the SEM image is maximized is a crack. The portion having a large difference in brightness from the other portions is large is a portion that looks black as compared with the other portions. Note that the appearance shape of the crack is, for example, an elongated linear shape or an elongated branched linear shape. It is preferable that the crack does not exist in the particle, because the crack can be a starting point of a particle fracture.

(First Embodiment)

A granulated particle for cold storage material particle according to a first embodiment contains: a rare earth oxysulfide or a rare earth oxide containing at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), in which the granulated particle has a plurality of recesses each having a closed curve at an outer edge on a surface thereof.

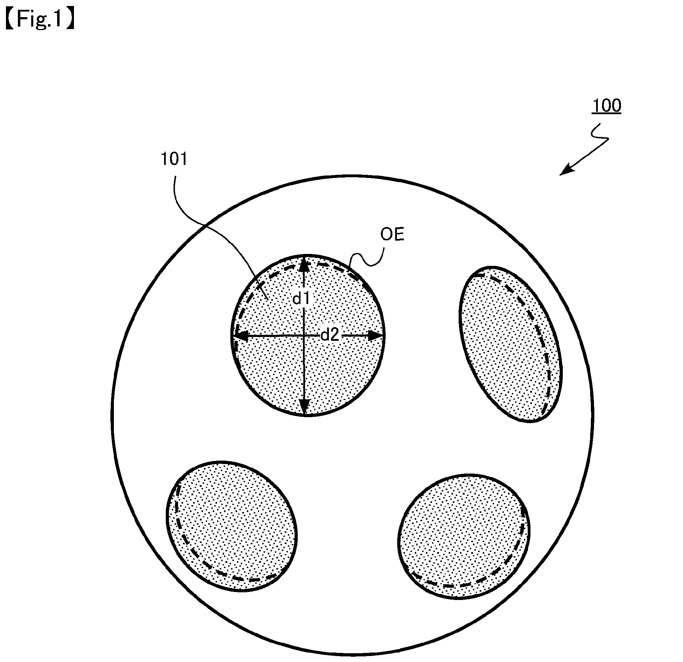

FIG. 1 is a schematic view of a granulated particle for cold storage material particle according to the first embodiment.

A granulated particle 100 for cold storage material particle according to the first embodiment is a granulated particle for producing a cold storage material particle. For example, a cold storage material particle is produced by subjecting the granulated particle 100 for cold storage material particle according to the first embodiment to a heat treatment for degreasing and a heat treatment for sintering. After the heat treatment for degreasing and before the heat treatment for sintering, the granulated particle 100 for cold storage material particle may be subjected to a heat treatment for sulfurization.

The granulated particle 100 for cold storage material particle is formed by, for example, gelling a plurality of raw material powders using a gelling agent (gelling solution), and then drying the gelled raw material powders. When the granulated particle 100 for cold storage material particle is formed from a gel, the granulated particle 100 for cold storage material particle includes, for example, a raw material powder, a dispersion medium, and a cavity. The dispersion medium contains, for example, a gelling agent. Hereinafter, the dispersion medium or the gelling agent after being dried is also referred to as the dispersion medium or the gelling agent.

The shape of the granulated particle 100 for cold storage material particle is, for example, a spherical shape or a spindle shape.

The granulated particle 100 for cold storage material particle has a particle diameter of, for example, 50 μm or more and 7 mm or less. In addition, the granulated particle 100 for cold storage material particle has an aspect ratio of, for example, 1 or more and 5 or less. The aspect ratio of the granulated particle 100 for cold storage material particle is a (long diameter/short diameter) ratio of a long diameter to a short diameter of the granulated particle 100 for cold storage material particle.

In the present specification, the particle diameter of the granulated particle 100 for cold storage material particle is an equivalent circle diameter. The equivalent circle diameter is a diameter of a perfect circle corresponding to an area of a figure observed in an image such as an optical microscope image or a scanning electron microscope image (SEM image). The particle diameter of the granulated particle 100 for cold storage material particle can be obtained, for example, by image analysis on an optical microscope image or an SEM image. The long diameter and the short diameter of the granulated particle 100 for cold storage material particle can be obtained, for example, from an optical microscope image or an SEM image. In addition, a border, which is a portion that is the recess, is determined to be, for example, a portion where the contrast of the SEM image or the like changes.

As illustrated in FIG. 1, the granulated particle 100 for cold storage material particle according to the first embodiment has a plurality of recesses 101 each having a closed curve at an outer edge OE on a surface thereof. The outer edge OE is, for example, a single closed curve that does not intersect. The outer edge OE does not have, for example, an acute angle portion. The outer edge OE is composed of, for example, only a curve.

The shape of the recess 101 is, for example, a circular shape or an elliptical shape. The circular shape or the elliptical shape may be a shape in which circles overlap each other or a shape in which circles are in contact with each other. In a case where a recess 101 has a shape in which circles are in contact with each other, the circles are regarded as two circles. On the other hand, In a case where a recess 101 has a shape in which circles overlap each other, the circles are regarded as one circle.

A long diameter (d1 in FIG. 1) of the recess 101 is, for example, 1/30 or more and 1/2 or less of the particle diameter of the granulated particle 100 for cold storage material particle. The long diameter of the recess 101 is, for example, 10 μm or more and 200 μm or less. Note that the long diameter of the recess 101 means a long diameter of the outer edge OE.

The aspect ratio of the long diameter to the short diameter (d2 in FIG. 1) of the recess 101 is, for example, 1 or more and 5 or less. The short diameter of the recess 101 is a length of the recess 101 in a direction perpendicular to a line segment corresponding to the long diameter of the recess 101 at the midpoint of the line segment. Note that the short diameter of the recess 101 means a short diameter of the outer edge OE. Note that the shape of the recess is observed from a direction substantially parallel to a depth direction of the recess such that the shape of the entire contour of the recess can be seen.

The recess 101 has a depth of, for example, 1/1000 or more and 1/50 or less of the particle diameter. The depth of the recess 101 is, for example, 0.1 μm or more and 10 μm or less.

The long diameter and the short diameter of the recess 101 can be obtained, for example, from an optical microscope image or an SEM image. In addition, the long diameter, the short diameter, and the depth of the recess 101 can be measured, for example, using a three-dimensional shape measuring device using a laser beam.

The number of recesses 101 is, for example, 4 or more and 20 or less.

The granulated particle 100 for cold storage material particle has a relative density of, for example, 10% or more and 50% or less.

For example, when the relative density of the granulated particle 100 for cold storage material particle is low, the volume proportion of the raw material powder in the granulated particle 100 for cold storage material particle is relatively small. When the relative density of the granulated particle 100 for cold storage material particle is low, the volume proportion of the dispersion medium or the voids in the granulated particle 100 for cold storage material particle is relatively high.

On the other hand, when the relative density of the granulated particle 100 for cold storage material particle is high, the volume proportion of the raw material powder in the granulated particle 100 for cold storage material particle is relatively high. When the relative density of the granulated particle 100 for cold storage material particle is high, the volume proportion of the dispersion medium or the voids in the granulated particle 100 for cold storage material particle is relatively low.

The relative density of the granulated particle 100 for cold storage material particle can be calculated, for example, by dividing an average molding density obtained from 50 granulated particles by the true density of the constituent material. The average molding density of the 50 granulated particles is obtained by dividing a mass of the 50 particles by a volume of the 50 particles. The volume of the 50 particles can be calculated by integrating volumes of the respective particles obtained by regarding an equivalent circle diameter of each particle as a diameter of the particle.

In the calculation of the true density of the granulated particle 100 for cold storage material particle, first, a crystal phase of the raw material powder constituting the granulated particle is identified by X-ray diffraction measurement. Then, a composition ratio of the raw material powder constituting the granulated particle is obtained from Rietveld analysis or inductively coupled plasma atomic emission spectroscopy on an X-ray diffraction pattern. The true density of the granulated particle 100 for cold storage material particle can be calculated from the crystal phase of the raw material powder and the composition ratio of the raw material powder.

The raw material powder contained in the granulated particle 100 for cold storage material particle contains a rare earth oxysulfide or a rare earth oxide. The rare earth oxysulfide contained in the raw material powder contains at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu). In addition, the rare earth oxide contained in the raw material powder contains at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu).

The rare earth oxysulfide contained in the raw material powder is, for example, a gadolinium oxysulfide or a holmium oxysulfide. The rare earth oxysulfide contained in the raw material powder is, for example, $Gd_2O_2S$, $Tb_2O_2S$, $Dy_2O_2S$, or $Ho_2O_2S$.

The rare earth oxide contained in the raw material powder is, for example, a gadolinium oxide or a holmium oxide. The rare earth oxide contained in the raw material powder is, for example, $Gd_2O_3$, $Tb_2O_3$, $Dy_2O_3$, or $Ho_2O_3$.

The raw material powder contains, for example, a carbonate, an oxide, a nitride, or a carbide containing a Group 1 element. The raw material powder contains, for example, a carbonate, an oxide, a nitride, or a carbide containing a Group 2 element.

The raw material powder contains, for example, a carbonate, an oxide, a nitride, or a carbide containing an additive element. The additive element is at least one element selected from the group consisting of manganese (Mn), aluminum (Al), iron (Fe), copper (Cu), nickel (Ni), cobalt (Co), zirconium (Zr), yttrium (Y), and boron (B).

In a case where a sintering aid is contained as the raw material powder, the sintering aid is, for example, an oxide. The sintering aid is, for example, an aluminum oxide (alumina), a magnesium oxide, an yttrium oxide, a zirconium oxide, or a boron oxide.

In a case where a dispersion medium is contained in the granulated particle 100 for cold storage material particle, the dispersion medium is an organic substance. The dispersion medium is, for example, an alginate. The dispersion medium is, for example, a sodium alginate, an ammonium alginate, or a potassium alginate.

The substance contained in the granulated particle 100 for cold storage material particle can be identified, for example, using a powder X-ray diffraction method.

The granulated particle 100 for cold storage material particle contains, for example, carbon. The concentration of carbon contained in the granulated particle 100 for cold storage material particle is, for example, 0.001 mass% or more and 50 mass% or less.

The carbon is contained, for example, in the dispersion medium. For example, when the relative density of the granulated particle 100 for cold storage material particle is low, the concentration of carbon is relatively high. For example, when the relative density of the granulated particle 100 for cold storage material particle is high, the concentration of carbon is relatively low.

The granulated particle 100 for cold storage material particle contains, for example, a Group 1 element. The Group 1 element is, for example, at least one element selected from the group consisting of lithium (Li), sodium (Na), and potassium (K).

The Group 1 element is contained in, for example, the raw material powder or the dispersion medium. The Group 1 element is derived from, for example, the gelling solution used when the granulated particle 100 for cold storage material particle is produced.

The Group 1 element contained in the granulated particle 100 for cold storage material particle has a concentration of, for example, 0.001 atom% or more and 60 atom% or less.

The granulated particle 100 for cold storage material particle contains, for example, a Group 2 element. The Group 2 element is, for example, at least one element selected from the group consisting of magnesium (Mg), calcium (Ca), strontium (Sr), and barium (Ba).

The Group 2 element is contained in, for example, the raw material powder or the dispersion medium. The Group 2 element is derived from, for example, the gelling solution used when the granulated particle 100 for cold storage material particle is produced.

The Group 2 element contained in the granulated particle 100 for cold storage material particle has a concentration of, for example, 0.001 atom% or more and 60 atom% or less.

The granulated particle 100 for cold storage material particle contains, for example, an additive element that is at least one element selected from the group consisting of manganese (Mn), aluminum (Al), iron (Fe), copper (Cu), nickel (Ni), cobalt (Co), zirconium (Zr), yttrium (Y), and boron (B).

The additive element is contained in, for example, the sintering aid. The additive element is derived from, for example, the sintering aid added when the granulated particle 100 for cold storage material particle is produced.

The additive element contained in the granulated particle 100 for cold storage material particle has a concentration of, for example, 0.001 atom% or more and 60 atom% or less.

The detection of the element contained in the granulated particle 100 for cold storage material particle and the measurement of the atomic concentration of the element can also be performed, for example, by dissolving the granulated particle in a liquid, using inductively coupled plasma atomic emission spectroscopy (ICP-AES). It is also possible to use energy dispersive X-ray spectroscopy (EDX) or wavelength dispersive X-ray spectroscopy (WDX).

Next, an example of a method for producing a granulated particle for cold storage material particle according to the first embodiment will be described.

A slurry prepared by adding a raw material powder to an alginate aqueous solution and mixing the raw material powder with the alginate aqueous solution is dropped into a gelling solution to gel the slurry. As a result, a granulated particle for cold storage material particle in a granular form can be obtained. This method is a method in which particles are granulated by causing gelation through a crosslinking reaction by polyvalent metal ions contained in the gelling solution.

By changing the ratio between the raw material powder and the alginate aqueous solution, the relative density of the granulated particle for cold storage material particle can be changed. The ratio of the mass of the raw material powder to the mass of the alginate aqueous solution is, for example, 0.1 times or more and 20 times or less.

The granulated particle for cold storage material particle is solidified in a granular form by the gelation of the alginate. Therefore, the strength of the granulated particle, that is, the gelation strength, changes depending on the amount of alginate contained in the particle or the viscosity of the alginate aqueous solution. For example, by adjusting the viscosity of the alginate aqueous solution, the alginate can retain the raw material powder in the gel, maintain the strength of the granulated particle for cold storage material particle, and obtain the granulated particle for cold storage material particle having a desired shape.

The slurry can be dropped into the gelling solution, for example, using a dropper, a burette, a pipette, a syringe, a dispenser, an inkjet, or the like. Hereinafter, the foregoing particle granulation method will be referred to as an alginate gel method.

In the alginate gel method, the particle diameter and the aspect ratio of the granulated particle for cold storage material particle can be changed by adjusting the viscosity of the slurry, the diameter of the discharge port at the time of dropping the slurry, or the distance between the tip of the discharge port and the liquid level of the gelling solution. The diameter of the discharge port is, for example, 50 $\mu$m or more and 3000 $\mu$m or less. The distance between the tip of the discharge port and the liquid level of the gelling solution is, for example, 0.1 mm or more and 1000 mm or less.

In a case where the dispenser is used for dispensing the slurry, any one of an air pulse type dispenser, a plunger type dispenser, and a piezo type dispenser may be used as the device.

The inkjet is largely classified as a continuous type inkjet or an on-demand type inkjet as an ejection method, but any type of ejection method may be used. Further, the on-demand type inkjet is classified as a piezo type inkjet, a thermal type inkjet, or a valve type inkjet, but any one of the three types of inkjets may be used.

The slurry dropped into the gelling solution by a dropper, a burette, a pipette, a syringe, a dispenser, an inkjet, or the like is gelled by being held in the gelling solution. By gelling the slurry, a gelled granulated particle containing the raw material powder of the cold storage material is formed. The time for which the slurry is held in the gelling solution is, for example, 10 minutes or more and 48 hours or less. If the gelation time is short, gelation does not sufficiently proceed, and accordingly, the strength of the granulated particle is low.

The alginate aqueous solution used in the alginate gel method is, for example, a sodium alginate aqueous solution, an ammonium alginate aqueous solution, or a potassium alginate aqueous solution. By using a sodium alginate aqueous solution or a potassium alginate aqueous solution containing a Group 1 element, sodium (Na) or potassium (K) can be contained in the granulated particle 100 for cold storage material particle. By using a mixed aqueous solution of a sodium alginate aqueous solution and a potassium alginate aqueous solution in the slurry, sodium (Na) and potassium (K) can be simultaneously contained in the granulated particle 100 for cold storage material particle.

The alginate has a concentration of, for example, 0.1 mass% or more and 5 mass% or less as an alginate aqueous solution. When the concentration of the alginate aqueous solution is lower than 0.1 mass%, a gel having sufficient strength cannot be generated, and a granulated particle for cold storage material particle cannot be obtained.

As the gelling solution, for example, a calcium lactate aqueous solution, a calcium chloride aqueous solution, a manganese (II) chloride aqueous solution, a magnesium sulfate aqueous solution, a beryllium sulfate aqueous solution, a strontium nitrate aqueous solution, a barium chloride aqueous solution, a barium hydroxide aqueous solution, an aluminum chloride aqueous solution, an aluminum nitrate aqueous solution, an aluminum lactate aqueous solution, an iron (II) chloride aqueous solution, an iron (III) chloride aqueous solution, a copper (II) chloride aqueous solution, a nickel (II) chloride aqueous solution, or a cobalt (II) chloride aqueous solution can be used.

By using a calcium lactate aqueous solution, a calcium chloride aqueous solution, a manganese (II) chloride aqueous solution, a magnesium sulfate aqueous solution, a beryllium sulfate aqueous solution, a strontium nitrate aqueous solution, a barium chloride aqueous solution, a barium hydroxide aqueous solution, an aluminum chloride aqueous solution, an aluminum nitrate aqueous solution, an aluminum lactate aqueous solution, an iron (II) chloride aqueous solution, an iron (III) chloride aqueous solution, a copper (II) chloride aqueous solution, a nickel (II) chloride aqueous solution, or a cobalt (II) chloride aqueous solution for the gelling solution, calcium (K), manganese (Mn), magnesium (Mg), beryllium (Be), strontium (Sr), barium (Ba), aluminum (Al), iron (Fe), copper (Cu), nickel (Ni), or cobalt (Co) can be contained in the granulated particle 100 for cold storage material particle.

In addition, by using an aluminum chloride aqueous solution, an aluminum nitrate aqueous solution, an aluminum lactate aqueous solution, an iron (II) chloride aqueous solution, an iron (III) chloride aqueous solution, a copper (II) chloride aqueous solution, a nickel (II) chloride aqueous solution, or a cobalt (II) chloride aqueous solution as the gelling solution, aluminum (Al), iron (Fe), copper (Cu), nickel (Ni), or cobalt (Co) can be contained in the granulated particle 100 for cold storage material particle.

Since gelation is caused through a crosslinking reaction by polyvalent metal ions contained in the gelling solution, in a case where an aqueous solution containing a Group 1 element is used for the slurry and an aqueous solution containing an element that forms polyvalent metal ions in the aqueous solution is used for the gelling solution, the amount of the Group 1 element contained in the particle and the amount of the element that forms polyvalent metal ions in the aqueous solution can be adjusted by adjusting a time for which the particle granulated by dropping the slurry into the gelling solution is immersed in the gelling solution.

The element that forms polyvalent ions in the aqueous solution is, for example, calcium (Ca), manganese (Mn), magnesium (Mg), beryllium (Be), strontium (Sr), barium (Ba), aluminum (Al), iron (Fe), copper (Cu), nickel (Ni), or cobalt (Co).

By using, as the gelling solution, a mixture of at least two kinds of aqueous solutions containing different metal elements selected from the group consisting of a calcium lactate aqueous solution, a calcium chloride aqueous solution, a manganese (II) chloride aqueous solution, a magnesium sulfate aqueous solution, a beryllium sulfate aqueous solution, a strontium nitrate aqueous solution, a barium chloride aqueous solution, a barium hydroxide aqueous solution, an aluminum chloride aqueous solution, an aluminum nitrate aqueous solution, an aluminum lactate aqueous solution, an iron (II) chloride aqueous solution, an iron (III) chloride aqueous solution, a copper (II) chloride aqueous solution, a nickel (II) chloride aqueous solution, and a cobalt (II) chloride aqueous solution, two or more kinds of elements forming polyvalent ions in the aqueous solutions can be contained in the granulated particle 100 for cold storage material particle.

A first example of a production method for forming a recess on a surface will be described. For example, after dropping the slurry into the gelling solution, in a state where the gelled granulated particles are immersed in the gelling solution, a predetermined vibration is applied to a container in which the granulated particles are immersed. The plurality of gelled granulated particles collide with each other due to the vibration, whereby granulated particles each having a plurality of recesses on a surface thereof. According to this production method, it is possible to obtain gelled granulated particles each having a plurality of recesses on the surface thereof. Even after drying the gelled granulated particles each having a plurality of recesses on the surface thereof, the recesses remain on the surfaces of the granulated particles.

The number, long diameter, short diameter, aspect ratio, or depth of the recesses on the surface of the granulated particle can be controlled by controlling the container vibrating condition.

A second example of a production method for forming a recess on a surface will be described. For example, a plurality of gelled granulated particles produced are put in a container and heated to be dried while being rotated. In this method, no recesses exist on the surfaces of the gelled granulated particles before being dried. The plurality of gelled granulated particles roll in the rotating container and collide with each other. The collision between the gelled granulated particles makes it possible to obtain granulated particles each having a plurality of recesses on the surface thereof after being dried.

The number, long diameter, short diameter, aspect ratio, or depth of the recesses on the surface of the granulated particle after being dried can be controlled by controlling the drying condition. The drying condition is, for example, the number of granulated particles to be placed in the container, the particle diameter distribution of the granulated particles to be placed in the container, the rotation speed of the container, the inclination angle of the rotation axis of the container, or the heating condition.

By the above-described production method, the granulated particle 100 for cold storage material particle according to the first embodiment illustrated in FIG. 1 can be produced.

Next, the function and effect of the granulated particle for cold storage material particle according to the first embodiment will be described.

A cold storage material particle is produced by subjecting the granulated particle for cold storage material particle to a heat treatment for degreasing and a heat treatment for sintering. The produced cold storage material particle is filled in, for example, a cold storage device of a refrigerator. It is desirable that the cold storage material particle has properties that improve the refrigeration performance of the refrigerator.

As illustrated in FIG. 1, the granulated particle 100 for cold storage material particle according to the first embodiment has a plurality of recesses 101 each having a closed curve at an outer edge OE on a surface thereof.

Since the granulated particle 100 for cold storage material particle has a plurality of recesses 101 on the surface, its specific surface area can be larger than a granulated particle having the same particle diameter. The specific surface area is a surface area per unit volume of a particle.

The recess 101 of the granulated particle 100 for cold storage material particle remains as a recess even in a cold storage material particle after the granulated particle 100 for cold storage material particle is heat-treated and sintered. Therefore, by increasing the specific surface area of the granulated particle 100 for cold storage material particle, a cold storage material particle produced from the granulated particle 100 for cold storage material particle can also have a large specific surface area.

By increasing the specific surface area of the cold storage material particle produced from the granulated particle 100 for cold storage material particle, a larger amount of helium gas can be brought into contact with the surface of the cold storage material particle when the cold storage material particle is filled in the cold storage device of the refrigerator. Therefore, the refrigeration performance of the refrigerator can be improved.

The outer edge OE of the recess 101 is preferably a single closed curve that does not intersect. In addition, the outer edge OE of the recess 101 preferably does not have an acute angle portion. In addition, the outer edge OE of the recess 101 is preferably composed of only a curve. Since the outer edge OE of the recess 101 has the above-described shape, the outer edge OE of the recess 101 does not have any singular point where a change in shape is large. As a result, it is possible to suppress a crack from propagating from the singular point where a change in shape is large. Therefore, the mechanical strength of the produced cold storage material particle is improved.

The shape of the recess 101 is preferably a circular shape or an elliptical shape. Since the shape of the recess 101 is a circular shape or an elliptical shape, the recess 101 does not have any singular point where a change in shape is large. As a result, the mechanical strength of the produced cold storage material particle is improved.

The long diameter of the recess 101 is preferably 1/30 or more and 1/2 or less, and more preferably 1/5 or more and 1/3 or less, of the particle diameter of the granulated particle 100 for cold storage material particle. When the long diameter of the recess 101 is larger than the lower limit value, the recess 101 has a large size. As a result, the produced cold storage material particle has a larger specific surface area. When the long diameter of the recess 101 is smaller than the upper limit value, the produced cold storage material particle is suppressed from having a distorted shape. As a result, the mechanical strength of the produced cold storage material particle is improved.

The long diameter of the recess 101 is preferably 10 μm or more and 200 μm or less, and more preferably 20 μm or more and 100 μm or less. When the long diameter of the recess 101 is larger than the lower limit value, the recess 101 has a large size. As a result, the produced cold storage material particle has a larger specific surface area. When the long diameter of the recess 101 is smaller than the upper limit value, the produced cold storage material particle is suppressed from having a distorted shape. As a result, the mechanical strength of the produced cold storage material particle is improved. In addition, the filling rate of the produced cold storage material particle in the cold storage device is improved.

The aspect ratio of the long diameter to the short diameter of the recess 101 is preferably 1 or more and 5 or less, and more preferably 3 or less. When the aspect ratio of the long diameter to the short diameter of the recess 101 is within the above-described range, an occurrence of a crack in the produced cold storage material particle is suppressed.

The depth of the recess 101 is preferably 1/1000 or more and 1/50 or less, and more preferably 1/500 or more and 1/100 or less, of the particle diameter. When the depth of the recess 101 is larger than the lower limit value, the recess 101 is deep. As a result, the produced cold storage material particle has a larger specific surface area. In addition, when the depth of the recess 101 is smaller than the upper limit value, the recess 101 is shallow. As a result, the mechanical strength of the produced cold storage material particle is improved.

The depth of the recess 101 is preferably 0.1 $\mu$m or more and 10 $\mu$m or less, and more preferably 0.5 $\mu$m or more and 2 $\mu$m or less. When the depth of the recess 101 is larger than the lower limit value, the recess 101 is deep. As a result, the produced cold storage material particle has a larger specific surface area. In addition, when the depth of the recess 101 is smaller than the upper limit value, the recess 101 is shallow. As a result, the mechanical strength of the produced cold storage material particle is improved.

The number of recesses 101 is preferably 4 or more and 20 or less, and more preferably 6 or more and 12 or less. When the number of recesses 101 is larger than the lower limit value, the produced cold storage material particle has a larger specific surface area. In addition, when the number of recesses 101 is smaller than the upper limit value, the produced cold storage material particle is suppressed from having a distorted shape. As a result, the mechanical strength of the produced cold storage material particle is improved. In addition, the filling rate of the produced cold storage material particle in the cold storage device is improved.

A cold storage material particle is produced by subjecting the granulated particle for cold storage material particle to a heat treatment for degreasing and a heat treatment for sintering. For example, in a case where the granulated particle for cold storage material particle contains an oxide raw material powder, the granulated particle for cold storage material particle may be subjected to a heat treatment for sulfurization after the heat treatment for degreasing and before the heat treatment for sintering.

By degreasing the granulated particle for cold storage material particle, a certain amount of an organic component contained in the binder or dispersion medium can be removed. For example, in a case where the raw material powder is an oxide, if degreasing is insufficient, the oxide is not sufficiently sulfurized, and as a result, a required amount of oxysulfide cannot be generated.

Furthermore, if the granulated particle for cold storage material particle is insufficiently degreased and the organic component remains in a large amount, the sintering reaction is also inhibited. When the sintering reaction is inhibited, the density of the cold storage material particle after sintering decreases. When the density of the cold storage material particle decreases, the strength of the cold storage material particle decreases, and there is a risk that the cold storage material particle is broken during use in a refrigerator. In addition, when the sintering reaction is inhibited, the volumetric specific heat of the cold storage material particle after sintering decreases. When the volumetric specific heat of the cold storage material particle decreases, the performance of the refrigerator decreases.

On the other hand, if the granulated particle for cold storage material particle is degreased too much, an organic component necessary for ensuring strength will disappear. For this reason, the strength of the granulated particle after degreased may decrease, and the granulated particle may be cracked or chipped.

The relative density of the granulated particle 100 for cold storage material particle according to the first embodiment is preferably 10% or more and 50% or less, preferably 15% or more and 45% or less, and more preferably 20% or more and 40% or less.

By setting the relative density of the granulated particle 100 for cold storage material particle to the upper limit value or less, it is easy to remove an organic component contained in the binder or the dispersion medium during the heat treatment for degreasing. As a result, for example, the temperature of the heat treatment for degreasing can be reduced, or the time of the heat treatment for degreasing can be shortened. In addition, for example, the temperature of the heat treatment for sulfurization can be reduced, or the time of the heat treatment for sulfurization can be shortened. In addition, for example, the temperature of the heat treatment for sintering can be reduced, or the time of the heat treatment for sintering can be shortened. Therefore, by reducing the temperature of the heat treatment or reducing the time of the heat treatment, it is possible to reduce the cost for producing a cold storage material particle produced from the granulated particle 100 for cold storage material particle according to the first embodiment.

By setting the relative density of the granulated particle 100 for cold storage material particle to the lower limit value or more, the ratio of voids in the cold storage material particle is reduced, and the strength of the granulated particle for cold storage material particle is improved. When the strength of the granulated particle for cold storage material particle is improved, it is easy to handle the granulated particle for cold storage material particle.

In addition, by setting the relative density of the granulated particle 100 for cold storage material particle to the lower limit value or more, excessive removal of the organic component during the heat treatment for degreasing is suppressed. By suppressing excessive removal of the organic component, the strength and the volumetric specific heat of the produced cold storage material particle are improved.

In addition, by setting the relative density of the granulated particle 100 for cold storage material particle to the lower limit value or more, the number of contact points between the raw material powders increases, improving the sinterability of the cold storage material particle. As a result, the volumetric specific heat of the cold storage material particle is improved.

The granulated particle 100 for cold storage material particle preferably contains carbon. The concentration of carbon contained in the granulated particle 100 for cold storage material particle is preferably 0.001 mass% or more and 50 mass% or less, more preferably 0.01 mass% or more and 10 mass% or less, and still more preferably 0.1 mass% or more and 5 mass% or less.

When the concentration of carbon contained in the granulated particle 100 for cold storage material particle is higher than or equal to the lower limit value, the strength of the granulated particle 100 for cold storage material particle is improved. As a result, it is easy to handle the granulated particle 100 for cold storage material particle.

When the concentration of carbon contained in the granulated particle 100 for cold storage material particle is lower than or equal to the upper limit value, carbon remaining at a crystal grain boundary of a cold storage material particle produced from the granulated particle 100 for cold storage material particle is reduced. Therefore, the thermal conductivity of the produced cold storage material particle is improved.

The granulated particle 100 for cold storage material particle according to the first embodiment preferably contains a Group 1 element. The concentration of the Group 1 element contained in the granulated particle 100 for cold storage material particle according to the first embodiment is preferably 0.001 atom% or more and 60 atom% or less, more preferably 0.01 atom% or more and 30 atom% or less, and still more preferably 0.1 atom% or more and 10 atom% or less.

When the concentration of the Group 1 element contained in the granulated particle 100 for cold storage material particle is within the above-described concentration range, the sinterability of the cold storage material particle produced from the granulated particle 100 for cold storage material particle can be improved. As a result, for example, the strength and the volumetric specific heat of the produced cold storage material particle are improved.

The granulated particle 100 for cold storage material particle according to the first embodiment preferably contains a Group 2 element. The concentration of the Group 2 element contained in the granulated particle 100 for cold storage material particle according to the first embodiment is preferably 0.001 atom% or more and 60 atom% or less, more preferably 0.01 atom% or more and 30 atom% or less, and still more preferably 0.1 atom% or more and 10 atom% or less.

When the concentration of the Group 2 element contained in the granulated particle 100 for cold storage material particle is within the above-described concentration range, the sinterability of the cold storage material particle produced from the granulated particle 100 for cold storage material particle can be improved. As a result, for example, the strength and the volumetric specific heat of the produced cold storage material particle are improved.

The granulated particle 100 for cold storage material particle contains according to the first embodiment preferably contains an additive element that is at least one element selected from the group consisting of manganese (Mn), aluminum (Al), iron (Fe), copper (Cu), nickel (Ni), cobalt (Co), zirconium (Zr), yttrium (Y), and boron (B). The concentration of the additive element contained in the granulated particle 100 for cold storage material particle according to the first embodiment is preferably 0.001 atom% or more and 60 atom% or less, more preferably 0.01 atom% or more and 30 atom% or less, and still more preferably 0.1 atom% or more and 10 atom% or less.

When the concentration of the additive element contained in the granulated particle 100 for cold storage material particle is within the above-described concentration range, the sinterability of the cold storage material particle produced from the granulated particle 100 for cold storage material particle can be improved. As a result, for example, the strength and the volumetric specific heat of the produced cold storage material particle are improved.

The granulated particle 100 for cold storage material particle according to the first embodiment preferably contains an aluminum oxide (alumina), a magnesium oxide, an yttrium oxide, a zirconium oxide, or a boron oxide. The oxide functions as a sintering aid. As the granulated particle 100 for cold storage material particle contains the above-described oxide, the sinterability of the produced cold storage material particle can be improved.

As described above, according to the first embodiment, it is possible to provide a granulated particle for cold storage material particle for producing a cold storage material particle having an increased specific surface area to improve the refrigeration performance of a refrigerator.

(Second Embodiment)

A granulated particle group for cold storage material particles according to a second embodiment is a granulated particle group for cold storage material particles including a plurality of the granulated particles for cold storage material particles according to the first embodiment, in which a number ratio of granulated particles for cold storage material particles according to the first embodiment is 50% or more. Hereinafter, some of the explanations overlapping with those in the first embodiment may be omitted.

The granulated particle group for cold storage material particles according to the second embodiment includes a plurality of the granulated particles 100 for cold storage material particles according to the first embodiment, each having a plurality of recesses 101 with a closed curve at an outer edge OE on a surface thereof. The number ratio of granulated particles 100 for cold storage material particles included in the granulated particle group for cold storage material particles is 50% or more.

When a cold storage material particle group obtained by sintering the granulated particle group for cold storage material particles according to the second embodiment is filled in a refrigerator, a larger amount of helium gas can be brought into contact with the surfaces of the cold storage material particles. As a result, the refrigeration performance of the refrigerator can be improved.

When a cold storage material particle group obtained by sintering the granulated particle group for cold storage material particles according to the second embodiment is filled in a refrigerator, from the viewpoint of further improving the refrigeration performance of the refrigerator, the number ratio of granulated particles 100 for cold storage material particles included in the granulated particle group for cold storage material particles is preferably 60% or more, and more preferably 70% or more.

As described above, according to the second embodiment, it is possible to provide a granulated particle group for cold storage material particles for producing a cold storage material particle group having an increased specific surface area to improve the refrigeration performance of a refrigerator.

(Third Embodiment)

A cold storage material particle according to a third embodiment is a cold storage material particle obtained by sintering the granulated particle for cold storage material particle according to the first embodiment. The cold storage material particle according to the third embodiment contains: a rare earth oxysulfide or a rare earth oxide containing at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu), in which the cold storage material particle has a plurality of recesses each having a closed curve at an outer edge on a surface thereof.

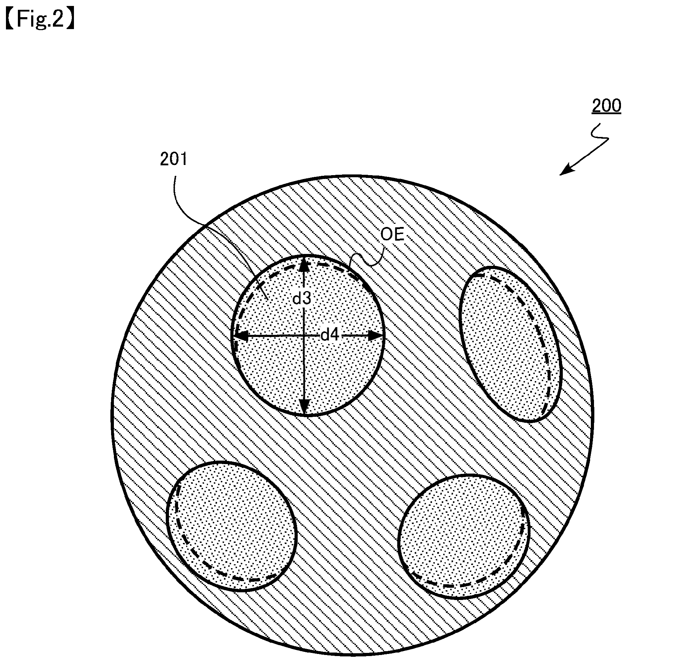

FIG. 2 is a schematic diagram of a cold storage material particle according to the third embodiment.

A cold storage material particle 200 according to the third embodiment is a cold storage material particle produced by sintering the granulated particle 100 for cold storage material particle according to the first embodiment.

The shape of the cold storage material particle 200 is, for example, a spherical shape or a spindle shape.

The cold storage material particle 200 has a particle diameter of, for example, 50 $\mu$m or more and 5 mm or less. In addition, the cold storage material particle 200 has an aspect ratio of, for example, 1 or more and 5 or less. The aspect ratio of the cold storage material particle 200 is a (long diameter/short diameter) ratio of a long diameter to a short diameter of the cold storage material particle 200.

The particle diameter of the cold storage material particle 200 is an equivalent circle diameter. The equivalent circle diameter is a diameter of a perfect circle corresponding to an area of a figure observed in an image such as an optical microscope image or a scanning electron microscope image (SEM image). The particle diameter of the granulated particle for cold storage material particle can be obtained, for example, by image analysis on an optical microscope image or an SEM image.

As illustrated in FIG. 2, the cold storage material particle 200 has a plurality of recesses 201 each having a closed curve at an outer edge OE on a surface thereof. The outer edge OE is, for example, a single closed curve that does not intersect. The outer edge OE does not have, for example, an acute angle portion. The outer edge OE is composed of, for example, only a curve.

The recess 201 of the cold storage material particle 200 according to the third embodiment is derived from the recess 101 of the granulated particle 100 for cold storage material particle according to the first embodiment before being sintered.

The shape of the recess 201 is, for example, a circular shape or an elliptical shape.

A long diameter (d3 in FIG. 2) of the recess 201 is, for example, 1/30 or more and 1/2 or less of the particle diameter of the cold storage material particle 200. The long diameter of the recess 201 is, for example, 10 $\mu$m or more and 200 $\mu$m or less. Note that the long diameter of the recess 201 means a long diameter of the outer edge OE.

The aspect ratio of the long diameter to the short diameter (d4 in FIG. 2) of the recess 201 is, for example, 1 or more and 5 or less. The short diameter of the recess 201 is a length of the recess 201 in a direction perpendicular to a line segment corresponding to the long diameter of the recess 201 at the midpoint of the line segment. Note that the short diameter of the recess 201 means a short diameter of the outer edge OE.

The recess 201 has a depth of, for example, 1/1000 or more and 1/50 or less of the particle diameter. The depth of the recess 201 is, for example, 0.1 $\mu$m or more and 10 $\mu$m or less.

The long diameter and the short diameter of the recess 201 can be obtained, for example, from an optical microscope image or an SEM image. In addition, the long diameter, the short diameter, and the depth of the recess 201 can be measured, for example, using a three-dimensional shape measuring device using a laser beam.

The number of recesses 201 is, for example, 4 or more and 20 or less.

The cold storage material particle 200 has a relative density of, for example, 90% or more.

The relative density of the cold storage material particle 200 can be calculated by dividing an average sintered density obtained from 50 cold storage material particles by the true density of the constituent material. The average sintered density of the 50 particles is determined by dividing masses of the 50 cold storage material particles by volumes of the 50 cold storage material particles. The volume of the 50 particles can be calculated by integrating volumes of the respective particles obtained by assuming an equivalent circle diameter of each particle as a diameter of the particle.

The cold storage material particle 200 according to the third embodiment is a cold storage material particle obtained from the granulated particle 100 for cold storage material particle according to the first embodiment. The cold storage material particle according to the third embodiment contains a rare earth oxysulfide or a rare earth oxide.

The crystal structure of the rare earth oxysulfide contained in the cold storage material particle 200 is, for example, a $Ce_2O_2S$ type, and its space group is P-3m. The crystal structure can be confirmed by powder X-ray diffraction measurement, observation of an electron backscatter diffraction image using a scanning electron microscope, transmission electron microscopy, or the like.

The crystal structure of the rare earth oxide contained in the cold storage material particle 200 is, for example, a perovskite type, and its space group is, for example, Pnma. In addition, the space group is, for example, Pm-3m. The crystal structure and the space group can be confirmed by powder X-ray diffraction measurement, observation of an electron backscatter diffraction image using a scanning electron microscope, transmission electron microscopy, or the like.

The rare earth oxysulfide contained in the cold storage material particle 200 contains at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu). In addition, the rare earth oxide contained in the cold storage material particle contains at least one rare earth element selected from the group consisting of yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), and lutetium (Lu).

The cold storage material particle 200 contains, for example, a rare earth oxysulfide represented by the general formula $R_{2\pm0.1}O_2S_{1\pm0.1}$ (where R denotes at least one rare earth element selected from the group consisting of Y, La, Ce, Pr, Nd, Sm, Eu, Gd, Tb, Dy, Ho, Er, Tm, Yb, and Lu).

In the rare earth oxysulfide represented by the above general formula, the maximum volumetric specific heat value and the temperature indicating the maximum volumetric specific heat value vary depending on the selected rare earth element. Therefore, the specific heat characteristic of the rare earth oxysulfide can be adjusted by appropriately adjusting the proportion of the rare earth element. The rare earth element is, for example, at least one element selected from the group consisting of Gd, Tb, Dy, Ho, and Er. The rare earth element may include, for example, two or more kinds of rare earth elements.

The cold storage material particle 200 contains, for example, a rare earth oxide represented by the general formula $R_{1\pm0.1}M_{1\pm0.1}O_{3\pm0.1}$ (where R denotes at least one element selected from the group consisting of Y, La, Ce, Pr, Nd, Sm, Eu, Gd, Tb, Dy, Ho, Er, Tm, Yb, and Lu, and M denotes at least one element selected from the group consisting of Al, Cr, Mn, and Fe).

In the rare earth oxide represented by the above general formula, the maximum volumetric specific heat value and the temperature indicating the maximum volumetric specific heat value vary depending on the selected rare earth element. Therefore, the specific heat characteristic of the rare earth oxide can be adjusted by appropriately adjusting the proportion of the rare earth element. The rare earth element is, for example, at least one element selected from the group consisting of Gd, Tb, Dy, Ho, and Er. The rare earth element may include, for example, two or more kinds of rare earth elements.

The cold storage material particle 200 contains, for example, a substance derived from the sintering aid of the granulated particle 100 for cold storage material particle according to the first embodiment as an oxide. The oxide is, for example, an aluminum oxide (alumina), a magnesium oxide, an yttrium oxide, a zirconium oxide, or a boron oxide.

The cold storage material particle 200 contains, for example, at least one additive element in an amount of 0.01 atom% or more and 20 atom% or less, the at least one additive element being selected from the group consisting of manganese (Mn), aluminum (Al), magnesium (Mg), iron (Fe), copper (Cu), nickel (Ni), cobalt (Co), zirconium (Zr), yttrium (Y), and boron (B). The additive element is, for example, an element derived from the sintering aid contained in the granulated particle 100 for cold storage material particle according to the first embodiment.

The cold storage material particle 200 contains, for example, a Group 1 element. The Group 1 element is, for example, at least one element selected from the group consisting of lithium (Li), sodium (Na), and potassium (K).

The Group 1 element is contained in, for example, the raw material powder or the dispersion medium. The Group 1 element is derived from, for example, the gelling solution used when the granulated particle 100 for cold storage material particle is produced.

The cold storage material particle 200 contains, for example, a Group 2 element. The Group 2 element is, for example, at least one element selected from the group consisting of magnesium (Mg), calcium (Ca), strontium (Sr), and barium (Ba).

The Group 2 element is contained in, for example, the raw material powder or the dispersion medium. The Group 2 element is derived from, for example, the gelling solution used when the granulated particle 100 for cold storage material particle is produced.

The cold storage material particle 200 has, for example, a volumetric specific heat of 0.5 J/(cm$^3$·K) or more in a temperature range of 2.5 K or more and 10 K or less.

Next, a method for producing a cold storage material particle according to the third embodiment will be described.

The cold storage material particle 200 according to the third embodiment is produced by subjecting the granulated particle 100 for cold storage material particle according to the first embodiment to a heat treatment for degreasing and a heat treatment for sintering. For example, in a case where the granulated particle 100 for cold storage material particle contains an oxide raw material powder, the granulated particle for cold storage material particle may be subjected to a heat treatment for sulfurization after the heat treatment for degreasing and before the heat treatment for sintering.

The heat treatment for degreasing is performed, for example, in an air atmosphere. The temperature of the heat treatment for degreasing is, for example, 400°C or more and 700°C or less. In addition, the time of the heat treatment for degreasing is, for example, 30 minutes or more and 6 hours or less.

In a case where an oxide is used in the raw material powder of the granulated particle 100 for cold storage material particle to produce a cold storage material particle containing an oxysulfide, the granulated particle 100 for cold storage material particle is sulfurized. In this case, the heat treatment is performed in a sulfurization atmosphere. The sulfurization atmosphere includes, for example, a gas containing a sulfur atom having a negative oxidation number, such as hydrogen sulfide ($H_2S$), carbon sulfide ($CS_2$), or methanethiol ($CH_3SH$). The temperature of the heat treatment for sulfurization is, for example, 400°C or more and 600°C or less. In addition, the time of the heat treatment for sulfurization is, for example, 1 hour or more and 5 hours or less.

The heat treatment for sintering the granulated particle after being degreased or the obtained oxysulfide is performed, for example, in an inert gas atmosphere.

The temperature of the heat treatment is, for example, 1100°C or more and 2000°C or less. The temperature of the heat treatment is, for example, 1200°C or more and 1800°C or less. The time of the heat treatment is, for example, 1 hour or more and 48 hours or less.

By the above-described production method, the cold storage material particle 200 according to the third embodiment illustrated in FIG. 2 can be produced.

Next, the function and effect of the cold storage material particle according to the third embodiment will be described.

The cold storage material particle is filled in, for example, a cold storage device of a refrigerator. It is desirable that the cold storage material particle has properties that improve the refrigeration performance of the refrigerator.

As illustrated in FIG. 2, the cold storage material particle 200 according to the third embodiment has a plurality of recesses 201 each having a closed curve at an outer edge OE on a surface thereof.

Since the cold storage material particle 200 has a plurality of recesses 201 on the surface, its specific surface area can be larger than a cold storage material particle having the same particle diameter. The recess 201 of the cold storage material particle 200 is derived from the recess 101 of the granulated particle 100 for cold storage material particle. Since the cold storage material particle 200 has a large specific surface area, a larger amount of helium gas can be brought into contact with the surface of the cold storage material particle when the cold storage material particle is filled in the cold storage device of the refrigerator. Therefore, according to the cold storage material particle 200, the refrigeration performance of the refrigerator can be improved.

The outer edge OE of the recess 201 is preferably a single closed curve that does not intersect. In addition, the outer edge OE of the recess 201 preferably does not have an acute angle portion. In addition, the outer edge OE of the recess 201 is preferably composed of only a curve. Since the outer edge OE of the recess 201 has the above-described shape, the outer edge OE of the recess 201 does not have any singular point where a change in shape is large. As a result, a crack is less likely to propagate from the singular point where a change in shape is large. Therefore, the mechanical strength of the cold storage material particle 200 is improved.

The shape of the recess 201 is preferably a circular shape or an elliptical shape. Since the shape of the recess 201 is a circular shape or an elliptical shape, the recess 201 does not have any singular point where a change in shape is large. As a result, the mechanical strength of the cold storage material particle 200 is improved.

The long diameter of the recess 201 is preferably 1/30 or more and 1/2 or less, and more preferably 1/5 or more and 1/3 or less, of the particle diameter of the cold storage material particle 200. When the long diameter of the recess 201 is larger than the lower limit value, the recess 201 has a large size. As a result, the cold storage material particle 200 has a larger specific surface area. When the long diameter of the recess 201 is smaller than the upper limit value, the cold storage material particle 200 is suppressed from having a distorted shape. As a result, the mechanical strength of the cold storage material particle 200 is improved.

The long diameter of the recess 201 is preferably 10 μm or more and 200 μm or less, and more preferably 20 μm or more and 100 μm or less. When the long diameter of the recess 201 is larger than the lower limit value, the recess 201 has a large size. As a result, the cold storage material particle 200 has a larger specific surface area. When the long diameter of the recess 201 is smaller than the upper limit value, the cold storage material particle 200 is suppressed from having a distorted shape. As a result, the mechanical strength of the cold storage material particle 200 is improved. In addition, the filling rate of the cold storage material particle 200 in the cold storage device is improved.

The aspect ratio of the long diameter to the short diameter of the recess 201 is preferably 1 or more and 5 or less, and more preferably 3 or less. When the aspect ratio of the long diameter to the short diameter of the recess 201 is within the above-described range, an occurrence of a crack in the cold storage material particle 200 is suppressed.

The depth of the recess 201 is preferably 1/1000 or more and 1/50 or less, and more preferably 1/500 or more and 1/100 or less, of the particle diameter. When the depth of the recess 201 is larger than the lower limit value, the recess 201 is deep. As a result, the cold storage material particle 200 has a larger specific surface area. In addition, when the depth of the recess 201 is smaller than the upper limit value, the recess 201 is shallow. As a result, the mechanical strength of the cold storage material particle 200 is improved.

The depth of the recess 201 is preferably 0.1 μm or more and 10 μm or less, and more preferably 0.5 μm or more and 2 μm or less. When the depth of the recess 201 is larger than the lower limit value, the recess 201 is deep. As a result, the cold storage material particle 200 has a larger specific surface area. In addition, when the depth of the recess 201 is smaller than the upper limit value, the recess 201 is shallow. As a result, the mechanical strength of the cold storage material particle 200 is improved.

The number of recesses 201 is preferably 4 or more and 20 or less, and more preferably 6 or more and 12 or less. When the number of recesses 201 is larger than the lower limit value, the cold storage material particle 200 has a larger specific surface area. When the number of recesses 201 is smaller than the upper limit value, the cold storage material particle 200 is suppressed from having a distorted shape. As a result, the mechanical strength of the cold storage material particle 200 is improved. In addition, the filling rate of the cold storage material particle 200 in the cold storage device is improved.

The number of recesses may be counted, for example, by the following method. One side of the cold storage material particle is imaged, the number of recesses is counted. Assuming that the number of recesses on the observation side of the cold storage material particle is the same as that on the back side of the cold storage material particle, twice the number of recesses on the observation side is simply taken as the total number of recesses. In the above method, for example, in a case where three recesses are observed when viewed from the observation side of the cold storage material particle, the total number of recesses of the cold storage material particle is determined to be six.

It is preferable that a distance ($d_{1,2}$) between the centers of the recesses satisfies the following formula (1) with respect to the radius r of the cold storage material particle.

$$r/4 \leq d_{1,2} \leq 3r \ ...(1)$$

In addition, the distance between the recesses more preferably satisfies the following formula (2).

$$3r/7 \leq d_{1,2} \leq 2r \ ...(2)$$

When a plurality of cold storage material particles are used, the number ratio of recesses satisfying either Formula (1) or Formula (2) is preferably 10% or more and 100% or less, and more preferably 25% or more and 95% or less, of the total number of recesses. It is preferable that the number ratio of recesses satisfying the positional relationship between the recesses is 100% if the cost is not taken into consideration. However, if number ratio of recesses satisfying the positional relationship between the recesses is 100%, the cost will be too high. On the other hand, when 10% or more of the recesses satisfy Formula (1) or (2), the effect of providing the recesses is easily obtained, which is preferable.

The particle diameter of the cold storage material particle 200 is preferably 50 μm or more and 5 mm or less, more preferably 1 mm or less, and still more preferably 500 μm or less. When the particle diameter of the cold storage material particle is larger than the lower limit value, the packing density of the cold storage material particle in the cold storage device is low, resulting in a reduction in pressure loss of the working medium such as helium, and an improvement in refrigeration performance of the refrigerator. On the other hand, when the particle diameter of the cold storage material particle is smaller than the upper limit value, a distance from the surface of the cold storage material particle to the central portion of the particle is short, making it easy to convey heat transfer between the working medium and the cold storage material particle to the central portion of the cold storage material, resulting in an improvement in refrigeration performance of the refrigerator.

In addition, when an average value of arithmetic mean roughnesses Ra(r) measured at three portions of a recess is compared with an average value of arithmetic mean roughnesses Ra(s) measured at three portions on the surface of the cold storage material particle 200 that are 50 μm or more away from the end of the recess, where the recess is not located, it is preferable that the average value of Ra(r) at the three portions is larger than the average value of Ra(s) at the three portions. It is more preferable that an absolute value of a difference between the average value of Ra(r) at the three portions and the average value of Ra(s) at the three portions is 0.001 μm or more and 5 μm or less.

Note that Ra is measured on the basis of JIS B 0601-2001(ISO 13565-1).

By controlling the arithmetic mean roughness Ra(s) of the surface of the cold storage material particle 200 where the recess is not located to be smaller than the arithmetic mean roughness Ra(r) of the recess, for example, when a plurality of cold storage material particles are arranged in a limited space, the cold storage material particles are less likely to get caught by or rub against each other. As a result, preferable arrangement of the cold storage material particles is easily realized.

On the other hand, when the arithmetic mean roughness Ra(r) of the recess is increased, the specific surface area can be increased, and the frequency of contact between the working medium such as helium and the surface of the recess of the cold storage material particle can be improved. As a result, the cooling effect is easily improved.

In addition, as a method of controlling the surface roughness as described above, for example, cold storage material particles may be formed into a substantially spherical shape by surface tension, and then the particles may be brought into contact with each other by vibration or the like.

The aspect ratio of the cold storage material particle 200 is preferably 1 or more and 5 or less, and more preferably 2 or less. When the aspect ratio of the cold storage material particle 200 is smaller than the upper limit value, voids when cold storage material particles 200 are filled in a cold storage device are uniform, improving the refrigeration performance of the refrigerator.

The relative density of the cold storage material particle 200 is preferably 90% or more, more preferably 93% or more, and still more preferably 95% or more. When the relative density of the cold storage material particle 200 is higher than or equal to the lower limit value, the mechanical strength and volumetric specific heat of the cold storage material particle 200 are improved.

The cold storage material particle 200 preferably contains a Group 1 element. The inclusion of the Group 1 element in the cold storage material particle 200 improves the strength and the volumetric specific heat of the cold storage material particle 200.

The cold storage material particle 200 preferably contains a Group 2 element. The inclusion of the Group 2 element in the cold storage material particle 200 improves the strength and the volumetric specific heat of the cold storage material particle 200.

The concentration of the additive element contained in the cold storage material particle 200 is preferably 20 atom% or less, the additive element being at least one element selected from the group consisting of manganese (Mn), aluminum (Al), iron (Fe), copper (Cu), nickel (Ni), cobalt (Co), zirconium (Zr), yttrium (Y), and boron (B). The additive element constituting the sintering aid does not exhibit specific heat characteristics. Therefore, by setting the concentration of the element to 20 atom% or less, a decrease in volumetric specific heat can be suppressed.

The cold storage material particle 200 has a maximum volumetric specific heat value of $0.5 \, J/(cm^3 \cdot K)$ or more in a temperature range of 2 K or more and 10 K or less. As a result, the cold storage material particle 200 according to the third embodiment has a high volumetric specific heat. Since the cold storage material particle 200 according to the third embodiment has a high volumetric specific heat, a cold storage device filled with the cold storage material particle 200 according to the third embodiment has high cold storage performance.

As described above, according to the third embodiment, it is possible to provide a cold storage material particle having an increased specific surface area to improve the refrigeration performance of a refrigerator.

(Fourth Embodiment)

A cold storage device according to a fourth embodiment is a cold storage device filled with a plurality of the cold storage material particles according to the third embodiment. The cold storage device according to the fourth embodiment is filled with, for example, a cold storage material particle group obtained by sintering the granulated particle group for cold storage material according to the second embodiment.

As described above, according to the fourth embodiment, it is possible to provide a cold storage device filled with the cold storage material particles according to the third embodiment to improve the refrigeration performance of a refrigerator.

(Fifth Embodiment)

A refrigerator according to a fifth embodiment is a refrigerator including the cold storage device according to the fourth embodiment filled with a plurality of the cold storage material particles according to the third embodiment. Hereinafter, some of the explanations overlapping with those in the third and fourth embodiments may be omitted.

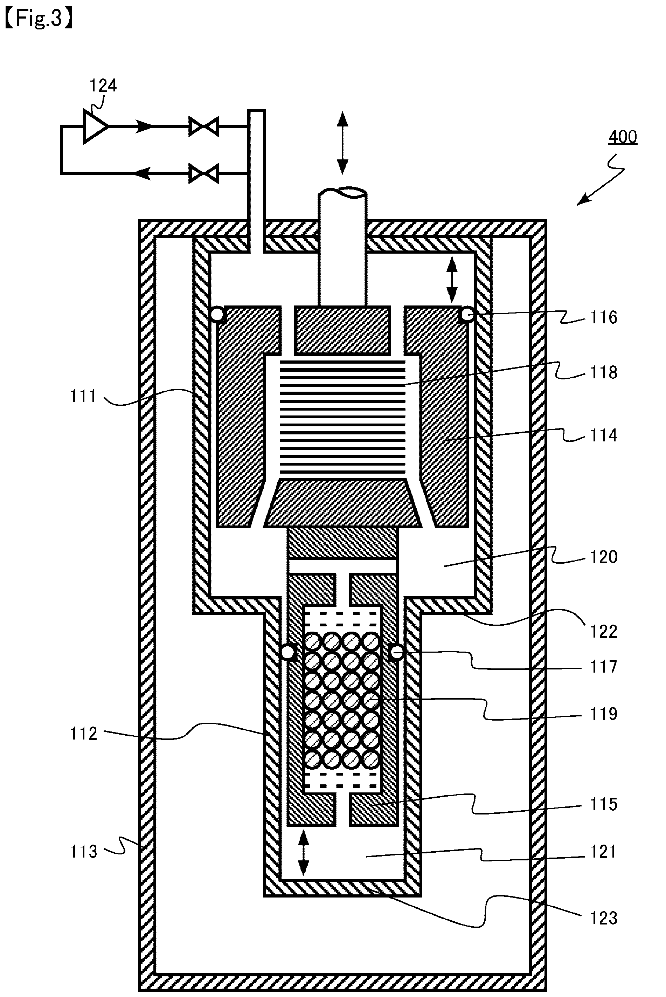

FIG. 3 is a schematic cross-sectional view illustrating a configuration of a main part of a refrigerator according to the fifth embodiment. The refrigerator according to the fifth embodiment is a two-stage cold storage cryogenic refrigerator 400 used for cooling a superconducting device or the like.

The cold storage cryogenic refrigerator 400 (refrigerator) includes a first cylinder 111, a second cylinder 112, a vacuum container 113, a first cold storage device 114, a second cold storage device 115 (cold storage device), a first seal ring 116, a second seal ring 117, a first cold storage material 118, a second cold storage material 119 (cold storage material particle), a first expansion chamber 120, a second expansion chamber 121, a first cooling stage 122, a second cooling stage 123, and a compressor 124.

The cold storage cryogenic refrigerator 400 includes a vacuum container 113 in which a large-diameter first cylinder 111 and a small-diameter second cylinder 112 coaxially connected to the first cylinder 111 are installed. The first cold storage device 114 is disposed in the first cylinder 111 so as to be reciprocable. The second cold storage device 115, which is an example of the cold storage device according to the fourth embodiment, is disposed in the second cylinder 112 so as to be reciprocable.

The first seal ring 116 is disposed between the first cylinder 111 and the first cold storage device 114. The second seal ring 117 is disposed between the second cylinder 112 and the second cold storage device 115.

The first cold storage device 114 is filled with the first cold storage material 118 such as a Cu mesh. The second cold storage device 115 is filled with a plurality of the cold storage material particles 200 according to the third embodiment as a second cold storage material 119.

The second cold storage device 115 may be divided by a metal mesh material and include a plurality of cold storage material-filled layers. In a case where the second cold storage device 115 is divided into a plurality of filled layers, at least one filled layer is filled with a cold storage material particle group including a plurality of the cold storage material particles according to the third embodiment, and is combined with, for example, at least one cold storage material particle group selected from a lead cold storage material particle group, a bismuth cold storage material particle group, a tin cold storage material particle group, a holmium copper cold storage material particle group, an erbium nickel cold storage material particle group, an erbium cobalt cold storage material particle group, and a gadolinium aluminum oxide cold storage material particle group.

In the combination of the cold storage materials, the cold storage materials are combined in such a manner that the peak temperature of specific heat is sequentially lowered, while a cold storage material having a higher peak temperature of specific heat is defined as a first cold storage material particle group, and a cold storage material having a lower peak temperature of specific heat is defined as a second cold storage material particle group.

In a case where the second cold storage device 115 is of a two-layer type, the combination of the cold storage materials may be a combination of a holmium copper cold storage material particle group for use as a first cold storage material particle group and a particle group including the cold storage material particles according to the third embodiment for use as a second cold storage material particle group. Further, in a case where the second cold storage device 115 is of a three-layer type, the combination of the cold storage materials may be a combination of at least one cold storage material particle group selected from a lead cold storage material particle group, a bismuth cold storage material particle group, and a tin cold storage material particle group for use as a first cold storage material particle group, a holmium copper cold storage material particle group for use as a second cold storage material particle group, and a particle group including the cold storage material particles according to the third embodiment for use as a third cold storage material particle group.

The holmium copper cold storage material particle is preferably, for example, $HoCu_2$ or $HoCu$. The erbium nickel cold storage material particle is preferably, for example, $ErNi$ or $Er_3Ni$.

Each of the first cold storage device 114 and the second cold storage device 115 has a working medium passage provided in a space in the first cold storage material 118 or the second cold storage material 119. The working medium is helium gas.

The first expansion chamber 120 is provided between the first cold storage device 114 and the second cold storage device 115. The second expansion chamber 121 is provided between the second cold storage device 115 and the distal end wall of the second cylinder 112. The first cooling stage 122 is provided at the bottom of the first expansion chamber 120. The second cooling stage 123 having a lower temperature than the first cooling stage 122 is formed at the bottom of the second expansion chamber 121.

A high-pressure working medium is supplied from the compressor 124 to the above-described two-stage cold storage cryogenic refrigerator 400. The supplied working medium passes through the first cold storage material 118 filled in the first cold storage device 114 and reaches the first expansion chamber 120. Then, the working medium passes through the second cold storage material 119 filled in the second cold storage device 115 and reaches the second expansion chamber 121.

At this time, the working medium is cooled by supplying thermal energy to the first cold storage material 118 and the second cold storage material 119. The working medium having passed through the first cold storage material 118 and the second cold storage material 119 expands in the first expansion chamber 120 and the second expansion chamber 121 to generate cold. Then, the first cooling stage 122 and the second cooling stage 123 are cooled.

The expanded working medium flows in the opposite direction through the first cold storage material 118 and the second cold storage material 119. The working medium is discharged after receiving thermal energy from the first cold storage material 118 and the second cold storage material 119. By improving the recuperation effect through such a process, the cold storage cryogenic refrigerator 400 is configured so that thermal efficiency in the working medium cycle is improved, thereby achieving a lower temperature.

As a cold storage device included in the refrigerator according to the fifth embodiment, the second cold storage device 115 is filled with a plurality of the cold storage material particles 200 according to the third embodiment as the second cold storage material 119. At least some of the second cold storage material 119 is the cold storage material particle 200 according to the third embodiment.

With respect to the plurality of cold storage material particles according to the third embodiment, when a perimeter of a projection image of each of the cold storage material particles is denoted by L and an actual area of the projection image is denoted by A, it is preferable that the proportion of cold storage material particles having a circularity R of 0.5 or less, the circularity R being represented by $4\pi A/L^2$, is 5% or less.

Although the GM refrigerator has been described above as an example of a refrigerator, the refrigerator may be another refrigerator including the cold storage device according to the fourth embodiment, for example, a Stirling type refrigerator or a pulse tube type refrigerator.

As described above, according to the fifth embodiment, a refrigerator having excellent characteristics can be realized by using cold storage material particles having excellent characteristics.

(Sixth Embodiment)

A cryopump according to a sixth embodiment includes the refrigerator according to the fifth embodiment. Hereinafter, some of the explanations overlapping with those in the fifth embodiment may be omitted.

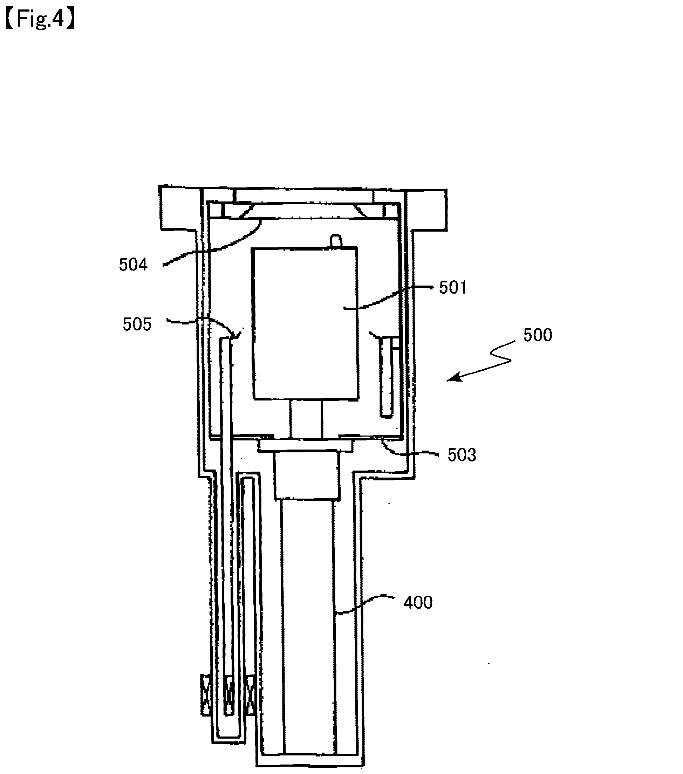

FIG. 4 is a cross-sectional view illustrating a schematic configuration of a cryopump according to the sixth embodiment. The cryopump according to the sixth embodiment is a cryopump 500 including the cold storage cryogenic refrigerator 400 according to the fifth embodiment.

The cryopump 500 includes a cryopanel 501 that condenses or adsorbs gas molecules, a cold storage cryogenic refrigerator 400 that cools the cryopanel 501 to a predetermined cryogenic temperature, a shield 503 provided between the cryopanel 501 and the cold storage cryogenic refrigerator 400, a baffle 504 provided at an intake port, and a ring 505 that changes an exhaust speed of argon, nitrogen, hydrogen, or the like.

According to the sixth embodiment, a cryopump having excellent characteristics can be realized by using a refrigerator having excellent characteristics. In addition, by using the cryopump according to the sixth embodiment in a semiconductor manufacturing device or the like, the long-term reliability of the semiconductor manufacturing device can be improved, and the number of times of maintenance of the semiconductor manufacturing device can be reduced. As a result, this contributes to an improvement in quality of a semiconductor to be manufactured and a reduction in semiconductor manufacturing cost.

(Seventh Embodiment)

A superconducting magnet according to a seventh embodiment includes the refrigerator according to the fifth embodiment. Hereinafter, some of the explanations overlapping with those in the fifth embodiment may be omitted.

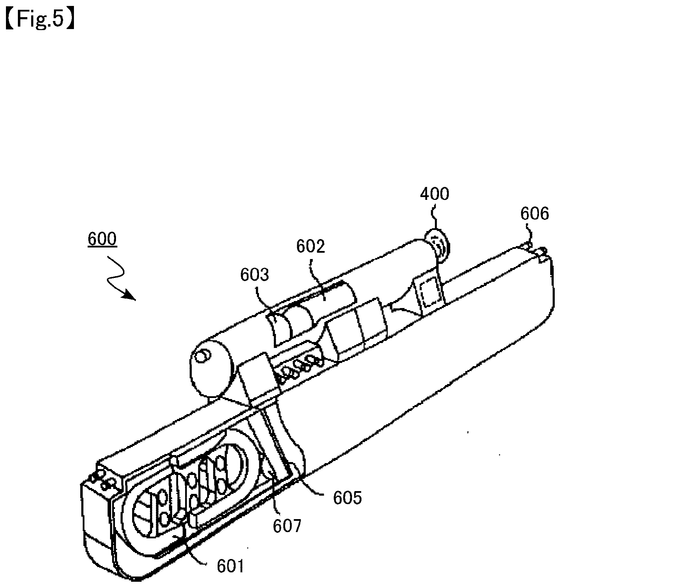

FIG. 5 is a perspective view illustrating a schematic configuration of a superconducting magnet according to the seventh embodiment. The superconducting magnet according to the seventh embodiment is, for example, a superconducting magnet 600 for magnetically levitated train including the cold storage cryogenic refrigerator 400 according to the fifth embodiment.

The superconducting magnet 600 for magnetically levitated train includes a superconducting coil 601, a liquid helium tank 602 for cooling the superconducting coil 601, a liquid nitrogen tank 603 for preventing volatilization of liquid helium, a laminated heat insulating material 605, a power lead 606, a permanent current switch 607, and a cold storage cryogenic refrigerator 400.

According to the seventh embodiment, a superconducting magnet having excellent characteristics can be realized by using a refrigerator having excellent characteristics.

(Eighth Embodiment)

A nuclear magnetic resonance imaging apparatus according to an eighth embodiment includes the refrigerator according to the fifth embodiment. Hereinafter, some of the explanations overlapping with those in the fifth embodiment may be omitted.

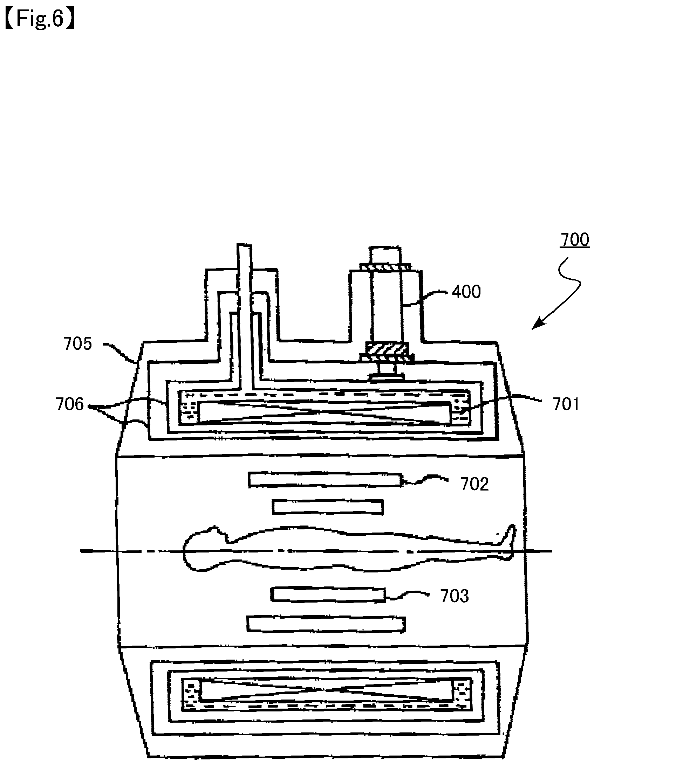

FIG. 6 is a cross-sectional view illustrating a schematic configuration of a nuclear magnetic resonance imaging apparatus according to the eighth embodiment. The nuclear magnetic resonance imaging (MRI) apparatus according to the eighth embodiment is a nuclear magnetic resonance imaging apparatus 700 including the cold storage cryogenic refrigerator 400 according to the fifth embodiment.

The nuclear magnetic resonance imaging apparatus 700 includes a superconducting static magnetic field coil 701 that applies a spatially uniform and temporally stable static magnetic field to a human body, a correction coil (not illustrated) that corrects nonuniformity of the generated magnetic field, a gradient magnetic field coil 702 that gives a magnetic field gradient to a measurement region, a radio wave transmission/reception probe 703, a cryostat 705, and a radiation adiabatic shield 706. In addition, the cold storage cryogenic refrigerator 400 is used for cooling the superconducting static magnetic field coil 701.

According to the eighth embodiment, a nuclear magnetic resonance imaging apparatus having excellent characteristics can be realized by using a refrigerator having excellent characteristics.

(Ninth Embodiment)

A nuclear magnetic resonance apparatus according to a ninth embodiment includes the refrigerator according to the fifth embodiment. Hereinafter, some of the explanations overlapping with those in the fifth embodiment may be omitted.

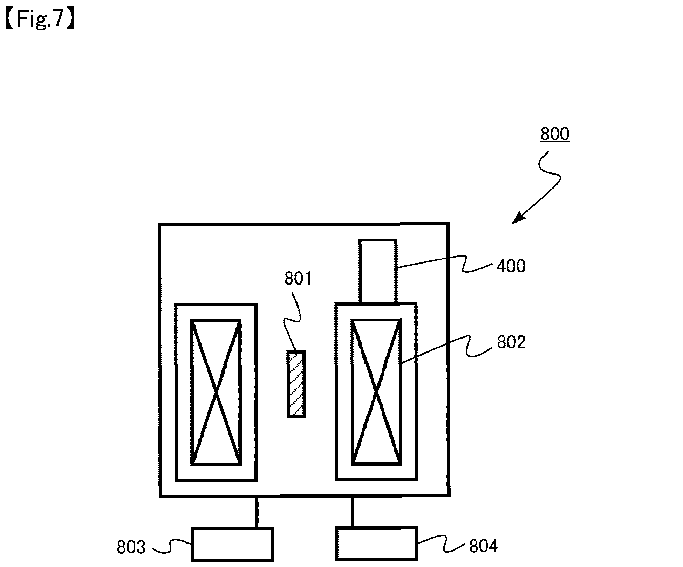

FIG. 7 is a cross-sectional view illustrating a schematic configuration of a nuclear magnetic resonance apparatus according to the ninth embodiment. The nuclear magnetic resonance (NMR) apparatus according to the ninth embodiment is a nuclear magnetic resonance apparatus 800 including the cold storage cryogenic refrigerator 400 according to the fifth embodiment.

The nuclear magnetic resonance apparatus 800 includes a superconducting static magnetic field coil 802 that applies a magnetic field to a sample such as an organic substance placed in a sample tube 801, a high frequency oscillator 803 that applies a radio wave to the sample tube 801 in the magnetic field, and an amplifier 804 that amplifies an induced current generated in a coil (not illustrated) around the sample tube 801. In addition, the nuclear magnetic resonance apparatus 800 includes a cold storage cryogenic refrigerator 400 that cools the superconducting static magnetic field coil 802.

According to the ninth embodiment, a nuclear magnetic resonance apparatus having excellent characteristics can be realized by using a refrigerator having excellent characteristics.

(Tenth Embodiment)

A magnetic field application type single crystal pulling apparatus according to a tenth embodiment includes the refrigerator according to the fifth embodiment. Hereinafter, some of the explanations overlapping with those in the fifth embodiment may be omitted.

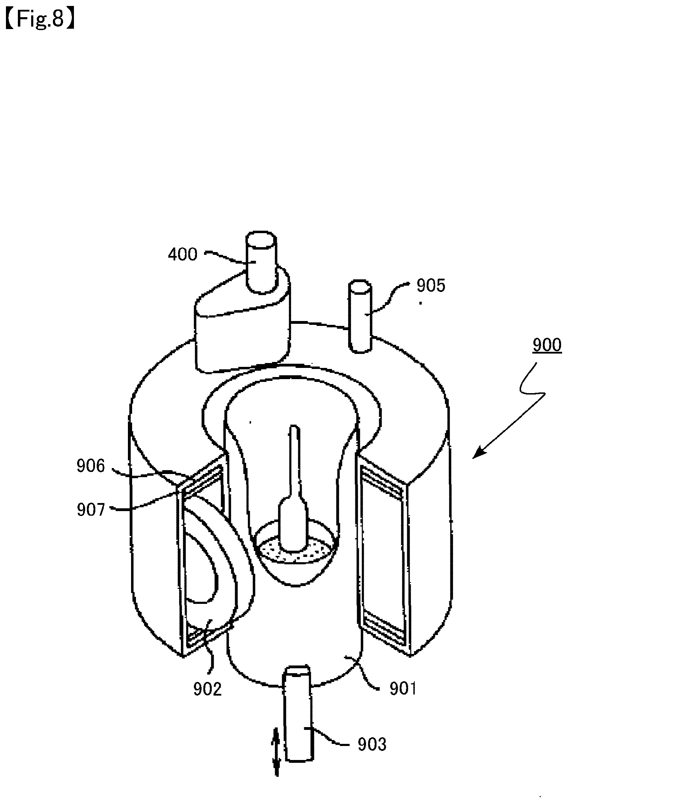

FIG. 8 is a perspective view illustrating a schematic configuration of a magnetic field application type single crystal pulling apparatus according to the tenth embodiment. The magnetic field application type single crystal pulling apparatus according to the tenth embodiment is a magnetic field application type single crystal pulling apparatus 900 including the cold storage cryogenic refrigerator 400 according to the fifth embodiment.

The magnetic field application type single crystal pulling apparatus 900 includes a single crystal pulling unit 901 having a raw material melting crucible, a heater, a single crystal pulling mechanism, etc., a superconducting coil 902 that applies a static magnetic field to a raw material melt, a lifting mechanism 903 for the single crystal pulling unit 901, a current lead 905, a heat shield plate 906, and a helium container 907. In addition, the cold storage cryogenic refrigerator 400 is used for cooling the superconducting coil 902.

According to the tenth embodiment, a magnetic field application type single crystal pulling apparatus having excellent characteristics can be realized by using a refrigerator having excellent characteristics.

(Eleventh Embodiment)

A helium re-condensing device according to an eleventh embodiment includes the refrigerator according to the fifth embodiment. Hereinafter, some of the explanations overlapping with those in the fifth embodiment may be omitted.

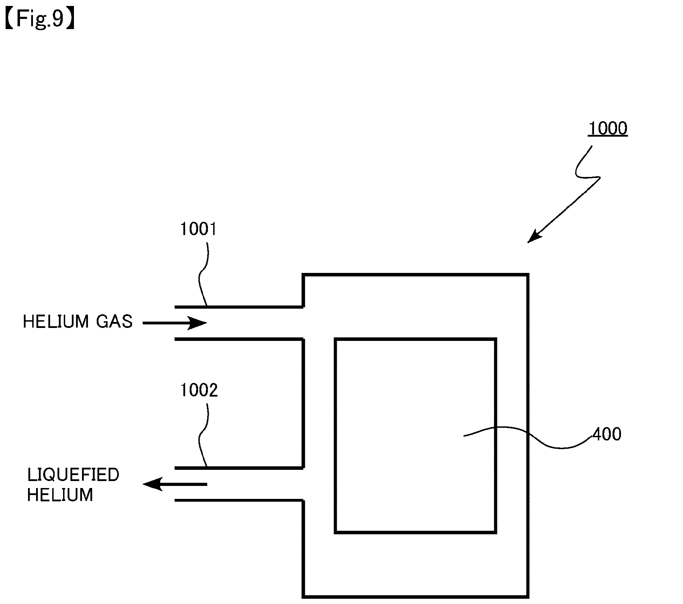

FIG. 9 is a schematic diagram illustrating a schematic configuration of a helium re-condensing device according to the eleventh embodiment. The helium re-condensing device according to the eleventh embodiment is a helium re-condensing device 1000 including the cold storage cryogenic refrigerator 400 according to the fifth embodiment.

The helium re-condensing device 1000 includes a cold storage cryogenic refrigerator 400, an evaporation pipe 1001, and a liquefaction pipe 1002.

The helium re-condensing device 1000 can recondense helium gas into liquid helium, the helium gas being evaporated from a device using liquid helium, e.g., a superconducting magnet, or a liquid helium device included in a device using a superconducting magnet such as a nuclear magnetic resonance (NMR) device, a nuclear magnetic resonance imaging (MRI) device, a physical property measurement system (PPMS), or a magnetic property measurement system.

The helium gas is introduced from a liquid helium device (not illustrated) into the helium re-condensing device 1000 through the evaporation pipe 1001. The helium gas is cooled to 4 K or less, which is a temperature for liquefaction of helium, by the cold storage cryogenic refrigerator 400. The condensed and liquefied liquid helium returns to the liquid helium device through the liquefaction pipe 1002.

According to the eleventh embodiment, a helium re-condensing device having excellent characteristics can be realized by using a refrigerator having excellent characteristics.

(Twelfth Embodiment)

A dilution refrigerator according to a twelfth embodiment includes the refrigerator according to the fifth embodiment. Hereinafter, some of the explanations overlapping with those in the fifth embodiment may be omitted.

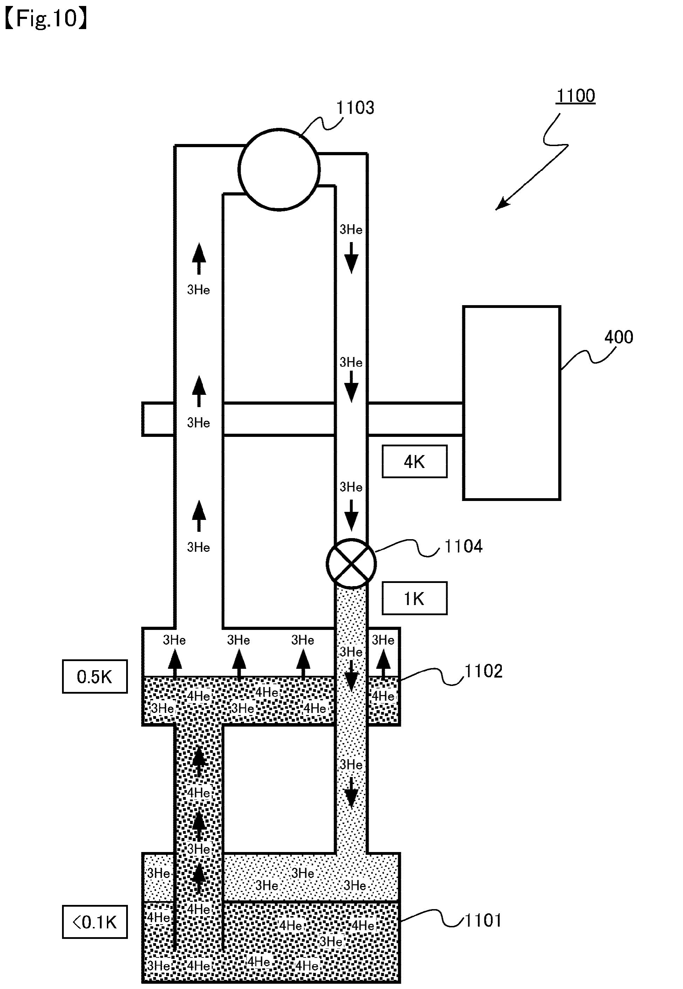

FIG. 10 is a schematic diagram illustrating a schematic configuration of a dilution refrigerator according to a twelfth embodiment. The dilution refrigerator according to the twelfth embodiment is a dilution refrigerator 1100 including the cold storage cryogenic refrigerator 400 according to the fifth embodiment.

The dilution refrigerator 1100 includes a mixing chamber 1101, a distillation chamber 1102, a circulation pump 1103, a Joule-Thomson valve 1104, and a cold storage cryogenic refrigerator 400.

Helium exists in two isotopes: normal helium 4 (4He) having an atomic weight of 4, and light helium 3 (3He) having an atomic weight of 3. The dilution refrigerator 1100 can realize a cryogenic temperature of, for example, less than 0.1 K by using dilution heat generated when mixing helium 4 and helium 3.

A mixed liquid of liquid helium 4 and liquid helium 3 exists in the mixing chamber 1101. In the mixing chamber 1101, an interface exists between liquid helium 4 and liquid helium 3 that are phase-separated. The mixing chamber 1101 has the lowest temperature. The temperature of the mixing chamber is, for example, less than 0.1 K.

The distillation chamber 1102 is connected to the mixing chamber 1101. The distillation chamber 1102 is maintained at, for example, 0.5 K. In the distillation chamber 1102, only helium 3 selectively evaporates and becomes gas.

The circulation pump 1103 has a function of circulating helium 3 that has become gas.

The cold storage cryogenic refrigerator 400 has a function of cooling helium 3 that has become gas to, for example, 4 K.

The Joule-Thomson valve 1104 has a function of liquefying helium 3 that has been cooled to, for example, 4 K.

The dilution refrigerator 1100 can realize a cryogenic temperature of, for example, less than 0.1 K, by forcibly dissolving liquid helium 3 in liquid helium 4 in the mixing chamber 1101.

According to the twelfth embodiment, a dilution refrigerator having excellent characteristics can be realized by using a refrigerator having excellent characteristics.

[Examples]

Hereinafter, examples of the granulated particle for cold storage material particle according to the first embodiment, the granulated particle group for cold storage material particles according to the second embodiment, and the cold storage material particle according to the third embodiment, comparative examples, and results of evaluation thereof will be described.

(Example 1)

A slurry was prepared by adding a $Gd_2O_3$ powder to a sodium alginate aqueous solution and mixing them for 12 hours. The sodium alginate aqueous solution was added so that the amount of sodium alginate was 2.3 mass% with respect to the raw material powder. The prepared slurry was dropped into a calcium lactate aqueous solution as a gelling solution. A syringe was used for dropping the slurry. The diameter of the syringe was 510 $\mu$m, and the distance from the tip of the syringe to the liquid level of the calcium lactate aqueous solution was 100 mm.

The slurry dropped with the syringe was held in the gelling solution for 5 hours. After granulated particles were gelled, in a state where the granulated particles were immersed in the gelling solution, the container was vibrated to cause the particles to collide with each other, thereby forming recesses on the surfaces of the particles.

Thereafter, the gelled granulated particles with the recesses formed on the surfaces were washed with pure water. After washing the particles, the particles were dried. After drying the particles, the number and sizes of recesses on the surface of each of the obtained granulated particles and the number ratio of granulated particles each having a plurality of recesses on the surface were confirmed by SEM images. Among the granulated particle group constituted by the granulated particles according to Example 1, the number ratio of granulated particles each having a particle diameter of 400 $\mu$m or more and 450 $\mu$m or less and having two or more elliptical recesses, each having a long diameter of 20 $\mu$m or more and 200 $\mu$m or less and a depth of 1 $\mu$m or more and 8 $\mu$m or less, was 60%. In addition, the granulated particles had a sodium concentration of 0.78 atom%, and a carbon concentration of 0.82 mass%.

The granulated particles were degreased at 600°C for 6 hours in an air atmosphere. After being degreased, the particles were subjected to a heat treatment at 500°C for 4 hours in an atmosphere containing hydrogen sulfide (H2S) to sulfurize the particles. The particles were sintered by performing a heat treatment at 1300°C for 12 hours in a pressurized inert gas atmosphere, thereby obtaining cold storage material particles in Example 1. The main component of the cold storage material particle in Example 1 is a gadolinium oxysulfide. The cold storage material particle in Example 1 had a sodium concentration of 0.83 atom%.

(Example 2)

Granulated particles, a granulated particle group, and cold storage material particles were produced in the same manner as in Example 1, except that, after granulated particles were gelled, a plurality of gelled granulated particles were put into a container and heated to be dried while being rotated, and the gelled granulated particles rolled in the rotating container and collided with each other, thereby forming a plurality of recesses on the surfaces of the particles, instead of performing a process of vibrating the container to cause the particles to collide with each other in a state where the granulated particles were immersed in the gelling solution.

Among the granulated particles according to Example 2, granulated particles each having a particle diameter of 400 $\mu$m or more and 450 $\mu$m or less and having two or more elliptical recesses, each having a long diameter of 25 $\mu$m or more and 200 $\mu$m or less and a depth of 0.8 $\mu$m or more and 8 $\mu$m, were 70% of the granulated particle group. In addition, the granulated particles had a sodium concentration of 0.81 atom%, and a carbon concentration of 0.85 mass%.

(Comparative Example 1)

Granulated particles, a granulated particle group, and cold storage material particles were produced in the same manner as in Example 1, except that, after the granulated particles were gelled, a process of vibrating the container to cause the particles to collide with each other in a state where the granulated particles were immersed in the gelling solution was not performed.

A refrigerator was assembled by concentrating a cold storage material particle group from a granulated particle group for cold storage material particles according to each of the examples and the comparative examples in an amount of 250 g on the low-temperature side of the second-stage cold storage device of the two-stage GM refrigerator illustrated in FIG. 3, while filling a Pb cold storage material in an amount of 250 g on the high-temperature side of the second-stage cold storage device, and a refrigeration test was performed to measure a refrigeration capacity at 4.2 K. Note that a thermal load was applied to the first-stage cold storage device so that the temperature was 50 K.

The refrigerators using the cold storage material particle groups according to Example 1 and Example 2 had significantly improved refrigerating capacities at 4.2 K as compared with the refrigerator using the cold storage material particle group according to the comparative example. This is considered to be because the specific surface area of the cold storage material particle in the embodiment is increased, and accordingly, a larger amount of helium gas comes into contact with the surface of the cold storage material particle, improving heat exchange efficiency.

Although some embodiments of the present invention have been described, these embodiments are exemplary, and are not intended to limit the scope of the invention. These novel embodiments can be implemented in various other forms, and various omissions, substitutions, and changes can be made without departing from the gist of the invention. For example, a component of one embodiment may be replaced or changed with a component of another embodiment. These embodiments and modifications thereof fall within the scope and gist of the invention, and fall within the scope of the equivalent to the invention set forth in the claims.

Reference Signs List

| | |
|---|---|
| 100 | Granulated particle for cold storage material particle |
| 101 | Recess |
| 115 | Second cold storage device (cold storage device) |
| 119 | Second cold storage material (cold storage material particle) |
| 200 | Cold storage material particle |
| 201 | Recess |
| 400 | Cold storage cryogenic refrigerator (refrigerator) |
| 500 | Cryopump |
| 600 | Superconducting magnet |
| 700 | Nuclear magnetic resonance imaging apparatus |
| 800 | Nuclear magnetic resonance apparatus |
| 900 | Magnetic field application type single crystal pulling apparatus |
| 1000 | Helium re-condensing device |
| 1100 | Dilution refrigerator |
| OE | Outer edge |

**Claims**

1. A granulated particle for cold storage material particle, the granulated particle comprising:

   a rare earth oxysulfide containing at least one rare earth element selected from the group consisting of Y, La, Ce, Pr, Nd, Sm, Eu, Gd, Tb, Dy, Ho, Er, Tm, Yb, and Lu, or a rare earth oxide containing the at least one rare earth element, wherein the granulated particle has a plurality of recesses each having a closed curve at an outer edge on a surface thereof.

2. The granulated particle for cold storage material particle according to claim 1, wherein a long diameter of the recess is 1/30 or more and 1/2 or less of a particle diameter.

3. The granulated particle for cold storage material particle according to claim 1, wherein an aspect ratio of a long diameter to a short diameter of the recess is 1 or more and 5 or less.

4. The granulated particle for cold storage material particle according to claim 1, wherein a depth of the recess is 1/1000 or more and 1/50 or less of a particle diameter.

5. The granulated particle for cold storage material particle according to claim 1, wherein the plurality of recesses is four or more recesses.

6. The granulated particle for cold storage material particle according to claim 1, wherein the granulated particle has a relative density of 10% or more and 50% or less.

7. The granulated particle for cold storage material particle according to claim 1, wherein the granulated particle has a particle diameter of 50 $\mu$m or more and 7 mm or less.

8. The granulated particle for cold storage material particle according to claim 1, wherein the granulated particle has an aspect ratio of 1 or more and 5 or less.

9. The granulated particle for cold storage material particle according to claim 1, further comprising a Group 1 element having a concentration of 0.001 atom% or more and 60 atom% or less.

10. The granulated particle for cold storage material particle according to claim 1, further comprising a Group 2 element having a concentration of 0.001 atom% or more and 60 atom% or less.

11. The granulated particle for cold storage material particle according to claim 1, further comprising an additive element having a concentration of 0.001 atom% or more and 60 atom% or less, the additive element being at least one element selected from the group consisting of Mn, Al, Fe, Cu, Ni, Co, Zr, Y, and B.

12. The granulated particle for cold storage material particle according to claim 9, wherein the Group 1 element is at least one element selected from the group consisting of Li, Na, and K.

13. The granulated particle for cold storage material particle according to claim 10, wherein the Group 2 element is at least one element selected from the group consisting of Mg, Ca, Sr, and Ba.

14. A granulated particle group for cold storage material particles, the granulated particle group comprising a plurality of granulated particles for cold storage material particles, wherein a number ratio of the granulated particle for cold storage material particle according to claim 1 is 50% or more.

15. A cold storage material particle obtained by sintering the granulated particle for cold storage material particle according to any one of claims 1 to 13.

16. The cold storage material particle according to claim 15, wherein a maximum volumetric specific heat value in a temperature range of 2 K or more and 10 K or less is 0.5 J/(cm$^3$·K) or more.

17. The cold storage material particle according to claim 15, wherein the cold storage material particle has a particle diameter of 50 $\mu$m or more and 5 mm or less.

18. The cold storage material particle according to claim 15, wherein the cold storage material particle has an aspect ratio of 1 or more and 5 or less.

19. A cold storage material particle group obtained by sintering the granulated particle group for cold storage material particles according to claim 14.

20. A cold storage device filled with a plurality of the cold storage material particles according to claim 15.

21. A refrigerator comprising the cold storage device according to claim 20.

22. A cryopump comprising the refrigerator according to claim 21.

23. A superconducting magnet comprising the refrigerator according to claim 21.

24. A nuclear magnetic resonance imaging apparatus comprising the refrigerator according to claim 21.

25. A nuclear magnetic resonance apparatus comprising the refrigerator according to claim 21.

26. A magnetic field application type single crystal pulling apparatus comprising the refrigerator according to claim 21.

27. A helium re-condensing device comprising the refrigerator according to claim 21.

28. A dilution refrigerator comprising the refrigerator according to claim 21.

【Fig.1】

【Fig.2】

【Fig.3】

400

124
111
112
113

116
118
114
120
122
117
119
115
121
123

【Fig.4】

【Fig.5】

【Fig.6】

【Fig.7】

【Fig.8】

【Fig.9】

【Fig.10】

## INTERNATIONAL SEARCH REPORT

| International application No. |
| --- |
| **PCT/JP2024/008875** |

**A. CLASSIFICATION OF SUBJECT MATTER**

*C09K 5/14*(2006.01)i; *F25B 9/00*(2006.01)i; *F25B 9/12*(2006.01)i
FI:   C09K5/14 F ZAA; F25B9/00 D; F25B9/12

According to International Patent Classification (IPC) or to both national classification and IPC

**B. FIELDS SEARCHED**

Minimum documentation searched (classification system followed by classification symbols)

C09K5/14; F25B

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| P, X | WO 2023/145730 A1 (KABUSHIKI KAISHA TOSHIBA) 03 August 2023 (2023-08-03) paragraphs [0083]-[0134], examples, claims, fig. 4 | 1-28 |
| X | WO 2023/032867 A1 (KABUSHIKI KAISHA TOSHIBA) 09 March 2023 (2023-03-09) paragraphs [0020]-[0103], examples, claims, fig. 1 | 1-28 |
| A | WO 2022/039150 A1 (KABUSHIKI KAISHA TOSHIBA) 24 February 2022 (2022-02-24) examples, claims | 1-28 |
| A | WO 2022/114045 A1 (KABUSHIKI KAISHA TOSHIBA) 02 June 2022 (2022-06-02) examples, claims | 1-28 |
| A | WO 2011/024757 A1 (KABUSHIKI KAISHA TOSHIBA) 03 March 2011 (2011-03-03) examples, claims, drawings | 1-28 |
| A | US 2019/0086159 A1 (AESTUS ENERGY STORAGE, LLC) 21 March 2019 (2019-03-21) drawings, claims | 1-28 |

☐ Further documents are listed in the continuation of Box C.      ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **22 April 2024** | **14 May 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| WO | 2023/145730 | A1 | 03 August 2023 | (Family: none) | | | |
| WO | 2023/032867 | A1 | 09 March 2023 | (Family: none) | | | |
| WO | 2022/039150 | A1 | 24 February 2022 | US | 2023/0279281 | A1 | |
| | | | | examples, claims | | | |
| | | | | EP | 4202319 | A1 | |
| | | | | CA | 3189966 | A1 | |
| | | | | CN | 115989389 | A | |
| | | | | IL | 300617 | A | |
| WO | 2022/114045 | A1 | 02 June 2022 | US | 2023/0303904 | A1 | |
| | | | | examples, claims | | | |
| | | | | EP | 4253868 | A1 | |
| | | | | CA | 3201508 | A1 | |
| | | | | CN | 116710715 | A | |
| | | | | IL | 302875 | A | |
| WO | 2011/024757 | A1 | 03 March 2011 | US | 2012/0157320 | A1 | |
| | | | | examples, claims, figures | | | |
| | | | | US | 2016/0305692 | A1 | |
| | | | | US | 2017/0082323 | A1 | |
| | | | | US | 2017/0299231 | A1 | |
| | | | | US | 2018/0320044 | A1 | |
| | | | | US | 2019/0309203 | A1 | |
| | | | | EP | 2472201 | A1 | |
| | | | | EP | 3285024 | A1 | |
| | | | | EP | 3663674 | A1 | |
| | | | | EP | 3933299 | A1 | |
| US | 2019/0086159 | A1 | 21 March 2019 | WO | 2019/104150 | A1 | |
| | | | | EP | 3714228 | A1 | |

Form PCT/ISA/210 (patent family annex) (July 2022)

**EP 4 682 220 A1**

## REFERENCES CITED IN THE DESCRIPTION

**Patent documents cited in the description**

- JP 2003073661 A
- JP 2003213252 A
- WO 2018025581 A1
- JP 5656842 B